(19) Europäisches Patentamt
European Patent Office
Office européen des brevets

(11) EP 2 253 033 B1

(12) **EUROPEAN PATENT SPECIFICATION**

(45) Date of publication and mention of the grant of the patent:
**12.06.2019 Bulletin 2019/24**

(21) Application number: **09723441.3**

(22) Date of filing: **19.03.2009**

(51) Int Cl.:
***H01L 51/44*** *(2006.01)*

(86) International application number:
**PCT/US2009/037724**

(87) International publication number:
**WO 2009/117613 (24.09.2009 Gazette 2009/39)**

(54) **METHOD FOR DETECTION OF INFRARED RADIATION USING ORGANIC THIN FILMS**

VERFAHREN ZUR DETEKTION VON INFRAROTER STRAHLUNG MITTELS ORGANISCHER DÜNNSCHICHTEN

MÉTHODE POUR LA DÉTECTION DE RADIATION INFRAROUGE À L'AIDE DE FILMS MINCES ORGANIQUES

(84) Designated Contracting States:
**AT BE BG CH CY CZ DE DK EE ES FI FR GB GR HR HU IE IS IT LI LT LU LV MC MK MT NL NO PL PT RO SE SI SK TR**

(30) Priority: **15.05.2008 US 53289**
**19.03.2008 US 70093**

(43) Date of publication of application:
**24.11.2010 Bulletin 2010/47**

(73) Proprietors:
- **The Regents of the University of Michigan Ann Arbor, MI 48109 (US)**
- **The University Of Southern California Los Angeles, CA 90089 (US)**

(72) Inventors:
- **FORREST, Stephen Ann Arbor MI 48104-1857 (US)**
- **THOMPSON, Mark, E. Anaheim CA 92807 (US)**
- **BAILEY-SALZMAN, Rhonda San Ramon CA 94583 (US)**

(74) Representative: **Maiwald Patent- und Rechtsanwaltsgesellschaft mbH Elisenhof Elisenstraße 3 80335 München (DE)**

(56) References cited:
**WO-A-2007/073467 WO-A-2007/121252**
**WO-A-2009/023667**

- **AJAY K PANDEY ET AL: "Features of light to current transformations in organic devices" NUMERICAL SIMULATION OF OPTOELECTRONIC DEVICES, 2007. NUSOD '07. INTERNATIONAL CONFERENCE ON, IEEE, PI, 1 September 2007 (2007-09-01), pages 59-60, XP031146966 ISBN: 978-1-4244-1431-4**
- **SÉBASTIAN FRAIGNE, JEAN-PIERRE GALAUP: "Near infrared spectral hole burning in Si-naphthalocyanine-doped solids: enhancement of the hole-burning efficiency by co-doping with C70 fullerene" SEVENTH INTERNATIONAL MEETING ON HOLE BURNING, SINGLE MOLECULE AND RELATED SPECTROSCOPIES: SCIENCE AND APPLICATIONS. HBSM 2001 18-23 NOV. 2001 TAIPEI, TAIWAN, vol. 98, no. 1-4, July 2002 (2002-07), pages 231-235, XP002538553 Journal of Luminescence Elsevier Netherlands ISSN: 0022-2313**
- **A. MARTÍ ET AL: "Production of Photocurrent due to Intermediate-to-Conduction-Band Transitions: A Demonstration of a Key Operating Principle of the Intermediate-Band Solar Cell", PHYSICAL REVIEW LETTERS, vol. 97, no. 24, 13 December 2006 (2006-12-13), pages 247701-1-247701-4, XP055405480, US ISSN: 0031-9007, DOI: 10.1103/PhysRevLett.97.247701**

Note: Within nine months of the publication of the mention of the grant of the European patent in the European Patent Bulletin, any person may give notice to the European Patent Office of opposition to that patent, in accordance with the Implementing Regulations. Notice of opposition shall not be deemed to have been filed until the opposition fee has been paid. (Art. 99(1) European Patent Convention).

EP 2 253 033 B1

## Description

### Field of the Invention

The present invention generally relates to a method of detecting infrared radiation.

### Background

Photodetectors are photosensitive devices that convert incident electromagnetic radiation into a measurable electrical signal. They are typically used in conjunction with current-detecting circuits, which measure the photocurrent generated when the photodetector is exposed to electromagnetic radiation.

Photodetectors may be classified according to whether a rectifying junction as defined below is present, and also according to whether the device is operated with an external applied voltage, also known as a bias or bias voltage. Photoconductor (or photoresistor) cells respond to incident radiation with a change in conductance; they do not have a rectifying junction and are normally operated with a bias. Photodiodes and photovoltaic devices respond to incident radiation with the generation of excitons. They have at least one rectifying junction; photodiodes are usually but not always operated with a bias.

As used herein, the term "rectifying" denotes, *inter alia,* that an interface has an asymmetric conduction characteristic, i.e., the interface supports electronic charge transport preferentially in one direction. The term "semiconductor" denotes materials which can conduct electricity when charge carriers are induced by thermal or electromagnetic excitation. The term "photoconductive" generally relates to the process in which electromagnetic radiant energy is absorbed and converted to excitation energy of electric charge carriers, so that the carriers can conduct (*i.e.,* transport) electric charge in a material. The term "photoconductive material" refers to semiconductor materials which are utilized for their capacity to generate electric charge carriers upon absorption of electromagnetic radiation. As used herein, the term "heterojunction" refers to a donor/acceptor semiconductor heterojunction, unless otherwise characterized.

Solid state electronic devices are most often constructed by deposition of various materials, in patterned layers, on a solid substrate. As used herein, "top" means furthest away from the substrate, while "bottom" means closest to the substrate. There may be intervening layers (for example, if a first layer is "on" or "over" a second layer), unless it is specified that the first layer is "in physical contact with" or "directly on" the second layer; the latter description does not preclude intervening surface treatments (e.g., exposure of the first layer to oxygen or hydrogen plasma, or ion implantation.)

When electromagnetic radiation of an appropriate energy is incident upon an organic semiconductor material, a photon can be absorbed to produce an excited molecular state. In organic photoconductive materials, the excited molecular state is generally believed to be an "exciton," an electron-hole pair in a bound state which is transported as a quasi-particle. An exciton can have an appreciable lifetime before geminate recombination ("quenching"), in which the original electron and hole recombine with each other (as opposed to recombination with holes or electrons from other pairs). To produce a photocurrent, the electron-hole pair forming the exciton are typically separated at a rectifying junction.

In the case of photosensitive devices, the rectifying junction is a heterojunction. Types of organic photovoltaic heterojunctions include donor-acceptor heterojunctions formed at an interface of a donor material and an acceptor material, and Schottky barrier heterojunctions formed at the interface of a photoconductive material and a metal.

The broad absorption spectra and high absorption coefficients ($\sim 10^5$ $cm^{-1}$) of organic materials, as well as the chemists' ability to tailor the electronic and photonic properties to suit a particular application or spectral range, make organic materials of particular interest for application to photodetection and solar energy conversion. P. Peumans, A. Yakimov, and S. R. Forrest, J. Appl. Phys. 93, 3693 (2003); C. W. Tang, Appl. Phys. Lett. 48, 183 (1986); A. Shah, P. Torres, R. Tscharner, N. Wyrsch, and H. Keppner, Science 285, 692 (1999); P. Peumans and S. R. Forrest, Appl. Phys. Lett. 79, 126 (2001). The low indices of refraction of the organic materials and their corresponding transparent substrates (glass or plastics) also allow for efficient light coupling into devices, leading to potentially high quantum efficiencies.

A significant property of organic semiconductors is carrier mobility. Mobility measures the ease with which a charge carrier can move through a conducting material in response to an electric field. In the context of organic photosensitive devices, a material that conducts preferentially by electrons due to high electron mobility may be referred to as an electron transport material. A material that conducts preferentially by holes due to high hole mobility may be referred to as a hole transport material. A layer that conducts preferentially by electrons, due to mobility and/or the position of the layer in the device, may be referred to as an electron transport layer ("ETL"). A layer that conducts preferentially by holes, due to mobility and/or the position of the layer in the device, may be referred to as a hole transport layer ("HTL").

For additional background explanation and description of the state of the art for organic photosensitive devices, including their general construction, characteristics, materials, and features, U.S. Patent No. 6,972,431 to Forrest and Xue, U.S. Patent No. 6,657,378 to Forrest et al.*,* U.S. Patent No. 6,580,027 to Forrest et al.*,* and U.S. Patent No.

6,352,777 to Bulovic et al. are mentioned. For a review, see P. Peumans, V. Bulovic, and S. R. Forrest, Appl. Phys. Lett. 76, 3855 (2000).

Photodetectors sensitive to infrared radiation are known in the art, and widely used in remote sensing, military and astronomy applications. Where sensitivity is paramount, cryogenic infrared photodetectors, typically made of small bandgap (about 0.1-0.2 eV) semiconductors such as HgCdTe, are commonly employed. The manufacturing cost of these detectors, especially in the form of imaging arrays, is high, the circuit designs are complex, and cryogenic temperatures are required, which adds to the complexity of the devices. In applications where the sensitivity of cryogenic detectors is not needed, less costly uncooled thermal detectors are available. These devices (e.g. pyrometers and bolometers) rely on the initial conversion of received infrared photons into heat. There is a need for infrared detectors that are sensitive, yet relatively simple and inexpensive.

Organic semiconductors are inexpensive to manufacture and lend themselves to mass production. However, in the field of organic photosensitive devices, there remains a need for devices having sensitivity to infrared radiation. Typical organic semiconductor band gaps are > 1.5eV, which is too large to permit excitation by infrared radiation, which carries at most about 0.3 eV. The present invention provides organic semiconductor devices capable of the detection of near- and mid-IR radiation.

Document WO 2007/073 467 A1 relates to an intermediate-band photosensitive device with quantum dots having a tunneling barrier embedded in organic matrix. Each of the quantum dots has a shell. The quantum dots are embedded in an organic matrix. The quantum dots and the matrix are photoconductive semiconductors. The shell of each quantum dot is arranged as a tunneling barrier to require charge carrier (an electron or a hole) at a base of the tunneling barrier in the organic matrix to perform quantum mechanical tunneling to reach the quantum dot.

The article "Near infrared spectral hole burning in Si-naphthalocyanine-doped solids: enhancement of the hole-burning efficiency by co-doping with C70 fullerene", written by S. Fraigne et al. and published in the "Journal of Luminescence", vol. 98, Issues 1-4, July 2002, pages 231-235, relates to to C70 fullerenes acting as an optical enhancer for the hole-burning properties of Si-naphthalocyanine (SiNPc)-doped PVP films in two-colour hole-burning experiments. The one-colour hole-burning efficiency of SiNPc has been increased, when $C_{70}$ is present.

Document WO 2007/1212 52 A2 relates to tandem photovoltaic cells.

The article "Features of light to current transformations in organic devices" published by Ajay K. Pandey, et al. and published in "International Conference on Numerical Simulation of Optoelectronic Devices", 2007, NUSOD ’07, pages 59 - 60 relates to a structure of organic semiconductors that permits efficient integration of both light and current generation functions from a rubene/fullerene heterostructure into an efficient organic dual device.

The article "Production of Photocurrent due to Intermediate-to-Conduction-Band Transitions: A Demonstration of a Key Operating Principle of the Intermediate-Band Solar Cell", written by A. Marti and published in the Physical Review Letters 97, 247701 (2006) relates to an intermediate-band solar cell which is manufactured using quantum dot technology. The solar cell shows the production of photocurrent when two sub-band-gap energy photons are absorbed simultaneously. One photon produces an optical transition from the intermediate band to the conduction band while the second pumps an electron from the valence band to the intermediate-band.

Accordingly, there is a need for a method of detecting infrared radiation. This need is met by the subject-matter of the independent claim.

## Summary of the Invention

According to an aspect of the invention a method of detecting infrared radiation comprises: (i) irradiating a photoconductive organic material with a pump light having a photon energy suitable for generating in said photoconductive organic material one or more first excitons having an energy level E that is within $\Delta E$ below $E_{min}$, wherein $E_{min}$ is the minimum excitation energy for generating charge carriers in said photoconductive organic material and $\Delta E$ is in the infrared region of the electromagnetic spectrum; (ii) exposing said photoconductive organic material to said infrared radiation, wherein absorption of said infrared radiation by said first exciton results in generation of charge carriers; and (iii) detecting said generated charge carriers. Said pump light is pulsed light. According to an embodiment $\Delta E$ is in the range of about 0.1 to about 1.7 eV. According to a further embodiment the pump light is visible and/or ultraviolet. According to a further embodiment the intensity of said pump light is selected such that a sufficient population of said first excitons is generated for sensitive charge detection. According to a further embodiment said one or more first excitons are singlet excitons. Said photoconductive organic material comprises a host material and a dopant material, and wherein said dopant material absorbs said pump light to generate said first exciton. Alternatively, said photoconductive organic material comprises a host material and a dopant material, and wherein said host material absorbs said pump light to generate an exciton in said host material which converts to said first exciton in said dopant material. According to a further embodiment said host material is selected from the group consisting of carbazole containing materials, arylamines, tetraarylphenylenediames, conjugated semiconducting polymers or polymer blends, phthalocyanines, porphyrins, transition metal complexes, $C_{60}$, polycyclic aromatics, and transition metal, actinide, and lanthanide complexes. According

to a further embodiment said dopant material is selected from the group consisting of metallophthalocyanines, metalloporphyrins, acenes, substituted acenes, and laser dyes. According to a further embodiment said photoconductive organic material comprises a host material and a dopant material, and wherein absorption of said infrared radiation by said first exciton results in generation of a second exciton which dissociates into charge carriers by relaxation to the LUMO of said dopant material. According to a further embodiment said photoconductive organic material is a donor material, and wherein said donor material is in contact with an acceptor material to form a rectifying junction. According to a further embodiment min is no less than the LUMO energy of said acceptor material. According to a further embodiment $E_{min}$ is about 50 mV higher than the LUMO energy of said acceptor material. According to a further embodiment said photoconductive organic material is an acceptor material, and wherein said acceptor material is in contact with a donor material to form a rectifying junction. According to a further embodiment $E_{min}$ is no higher than the HOMO energy of said acceptor material. According to a further embodiment $E_{min}$ is about 50 mV lower than the HOMO energy of said acceptor material. According to a further embodiment said donor material comprises a material selected from the group consisting of carbazole containing materials, arylamines, tetraarylphenylenediames, oligothiophenes, phenylenevinylenes, oligopyrroles, tetrathiafulvalene and its derivatives, conjugated semiconducting polymers or polymer blends, phthalocyanines, porphyrins, acenes and substituted acenes, carbon nanotubes, coordination compounds and organometallic complexes. According to a further embodiment said acceptor material comprises a material selected from the group consisting of F16CoPc, F16ZnPc, NiTPP, tetracyanoethylene, tetracyanoquinuclidine and its derivatives, fullerenes, polycyclic aromatics, coordination compounds and organometallic complexes. According to a further embodiment said rectifying junction is a planar rectifying junction, a mixed heterojunction, or a bulk heterojunction. According to a further embodiment said one or more first excitons are triplet excitons. According to a further embodiment said pump light generates in said photoconductive organic material one or more singlet excitons which convert to said one or more first triplet excitons, and wherein absorption of said infrared radiation by said one or more first triplet excitons results in generation one or more second triplet excitons which dissociate into charge carriers. According to a further embodiment said photoconductive organic material comprises a host material and a phosphorescent dopant material, wherein said pump light generates in said phosphorescent dopant material one or more singlet excitons which convert to said first triplet excitons in said phosphorescent dopant material. According to a further embodiment said photoconductive organic material comprises a host material and a phosphorescent dopant material, wherein said pump light generates in said host material one or more singlet excitons which convert to said first triplet excitons in said phosphorescent dopant material. According to a further embodiment said singlet excitons convert to said first triplet excitons on a time scale less than a time scale for charge separation. According to a further embodiment said singlet excitons convert to said first triplet excitons on a time scale less than about 1 picosecond. According to a further embodiment said host material is selected from the group consisting of carbazole containing materials, arylamines, tetraarylphenylenediames, oligothiophenes, phenylenevinylenes, oligopyrroles, tetrathiafulvalene and its derivatives, conjugated semiconducting polymers or polymer blends, phthalocyanines, porphyrins, acenes and substituted acenes, carbon nanotubes, coordination compounds and organometallic complexes. According to a further embodiment said phosphorescent dopant material is selected from the group consisting of metalloporphyrins and phthalocyanines with heavy metal ions having an atomic number greater than 40; organometallic complexes with metal ions having an atomic number greater than 40; and metal complexes with metal ions having an atomic number less than 40 and intersystem crossing efficiencies greater than 25%. According to a further embodiment said phosphorescent dopant material is an organometallic complex of Ir or Pt. According to a further embodiment said pump light generates in said photoconductive organic material said one or more first triplet excitons by direct singlet-triplet transition, and wherein absorption of said infrared radiation by said one or more first triplet exciton results in generation one or more second triplet excitons which dissociate into charge carriers. According to a further embodiment said host material has singlet and triplet exciton levels nested in singlet and triplet exciton levels of said phosphorescent dopant material. According to a further embodiment said host material is (1np)Pt(dpm) or (btp)Pt(dpm), and wherein said phosphorescent dopant material is rubrene. According to a further embodiment said photoconductive organic material comprises a host material, a phosphorescent dopant material and a sensitizer material, wherein said pump light generates in said sensitizer material one or more singlet excitons which convert to said first triplet excitons in said phosphorescent dopant material. According to a further embodiment said sensitizer material has singlet and triplet exciton levels nested in singlet and triplet exciton levels of said phosphorescent dopant material. According to a further embodiment said host material is selected from the group consisting of carbazole containing materials, arylamines, tetraarylphenylenediames, oligothiophenes, phenylenevinylenes, oligopyrroles, tetrathiafulvalene its derivatives, conjugated semiconducting polymers or polymer blends, phthalocyanines, porphyrins, acenes and substituted acenes, carbon nanotubes, coordination compounds and organometallic complexes. According to a further embodiment said phosphorescent dopant material is selected from the group consisting of metalloporphyrins and phthalocyanines with heavy metal ions having an atomic number greater than 40; organometallic complexes with metal ions having an atomic number greater than 40; and metal complexes with metal ions having an atomic number less than 40 and intersystem crossing efficiencies greater than 25%. According to a further embodiment said sensitizer material is selected from the group consisting of metalloporphyrins and phthalocyanines with heavy metal ions having an atomic number greater than 40;

organometallic complexes with metal ions having an atomic number greater than 40; and metal complexes with metal ions having an atomic number less than 40 and intersystem crossing efficiencies greater than 25%. According to a further embodiment said photoconductive organic material is a donor material, wherein said donor material is in contact with an acceptor material to form a rectifying junction. According to a further embodiment $E_{min}$ is no less than the LUMO energy of said acceptor material. According to a further embodiment $E_{min}$ is about 50 mV higher than the LUMO energy of said acceptor material. According to a further embodiment said photoconductive organic material is an acceptor material, wherein said acceptor material is in contact with a donor material to form a rectifying junction. According to a further embodiment $E_{min}$ is no higher than the HOMO energy of said acceptor material. According to a further embodiment $E_{min}$ is about 50 mV lower than the HOMO energy of said acceptor material. According to a further embodiment said donor material comprises a material selected from the group consisting of carbazole containing materials, arylamines, tetraarylphenylenediames, oligothiophenes, phenylenevinylenes, oligopyrroles, tetrathiafulvalene its derivatives, conjugated semiconducting polymers or polymer blends, phthalocyanines, porphyrins, acenes and substituted acenes, carbon nanotubes, coordination compounds and organometallic complexes. According to a further embodiment said acceptor material comprises a material selected from the group consisting of F16CoPc, F16ZnPc, NiTPP, tetracyanoethylene, tetracyanoquinuclidine and its derivatives, fullerenes, polycyclic aromatics, coordination compounds and organometallic complexes. According to a further embodiment said rectifying junction is a planar rectifying junction, a mixed heterojunction, or a bulk heterojunction.

According to an example an organic photosensitive optoelectronic device useful for understanding the invention for detecting infrared radiation comprises (i) a first electrode and a second electrode; and (ii) a photoconductive organic material disposed between the first electrode and the second electrode, wherein said photoconductive organic material is capable of absorbing visible and/or ultraviolet light to generate one or more first excitons having an energy level E that is within $\Delta E$ below $E_{min}$, wherein $E_{min}$ is the minimum excitation energy for generating charge carriers in said photoconductive organic material and $\Delta E$ is in the infrared region of the electromagnetic spectrum. According to an embodiment the organic photosensitive optoelect ronic device further comprises a source of visible and/or ultraviolet light disposed so as to illuminate the organic photoconductive material. According to a further embodiment the organic photosensitive optoelectronic device further comprises at least one exciton blocking layer between the two electrodes and adjacent to at least one of the two electrodes. According to a further embodiment $\Delta E$ is in the range of about 0.1 to about 1.7 eV. According to a further embodiment said visible and/or ultraviolet light is pulsed light. According to a further embodiment the intensity of said visible and/or ultraviolet light is selected such that a sufficient population of said first excitons is generated for sensitive charge detection. According to a further embodiment said first excitons are first triplet excitons, and wherein said photoconductive organic material comprises a host material and a phosphorescent dopant material, wherein said host material is capable of absorbing said visible and/or ultraviolet light to generate one or more singlet excitons which convert to said first triplet excitons in said phosphorescent dopant material. According to a further embodiment said host material has singlet and triplet exciton levels nested within singlet and triplet exciton levels of said phosphorescent dopant material. According to a further embodiment said host material is (lnp)Pt(dpm) or (btp)Pt(dpm), and wherein said phosphorescent dopant material is rubrene. According to a further embodiment said first excitons are first triplet excitons, and wherein said photoconductive organic material comprises a host material, a phosphorescent dopant material and a sensitizer material,

wherein said sensitizer material is capable of absorbing said visible and/or ultraviolet light to generate one or more singlet excitons which convert to said first triplet excitons in said phosphorescent dopant material. According to a further embodiment said sensitizer material has singlet and triplet exciton levels nested in singlet and triplet exciton levels of said phosphorescent dopant. According to a further embodiment said host material is selected from the group consisting of carbazole containing materials, arylamines, tetraarylphenylenediames, oligothiophenes, phenylenevinylenes, oligopyrroles, tetrathiafulvalene and its derivatives, conjugated semiconducting polymers or polymer blends, phthalocyanines, porphyrins, acenes and substituted acenes, carbon nanotubes, coordination compounds and organometallic complexes. According to a further embodiment said phosphorescent dopant material is selected from the group consisting of mctalloporphyrins and phthalocyanines with heavy metal ions having an atomic number greater than 40; organometallic complexes with metal ions having an atomic number greater than 40; and metal complexes with metal ions having an atomic number less than 40 and intersystem crossing efficiencies greater than 25%.. According to a further embodiment said sensitizer material is selected from the group consisting of metalloporphyrins and phthalocyanines with heavy metal ions having an atomic number greater than 40; organometallic complexes with metal ions having an atomic number greater than 40; and metal complexes with metal ions having an atomic number less than 40 and intersystem crossing efficiencies greater than 25%. According to a further embodiment said photoconductive organic material is a donor material, wherein said donor material is in contact with an acceptor material to form a rectifying junction. According to a further embodiment $E_{min}$ is no less than the LUMO energy of said acceptor material. According to a further embodiment $E_{min}$ is about 50 mV higher than the LUMO energy of said acceptor material. According to a further embodiment said photoconductive organic material is an acceptor material, wherein said an acceptor material is in contact with a donor material, wherein said acceptor material and said donor material form a rectifying junction. According to a further em-

bodiment $E_{min}$ is no higher than the HOMO energy of said acceptor material. According to a further embodiment $E_{min}$ is about 50 mV lower than the HOMO energy of said acceptor material. According to a further embodiment said donor material comprises a material selected from the group consisting of carbazole containing materials, arylamines, tetraarylphenylenediames, oligothiophenes, phenylenevinylenes, oligopyrroles, tetrathiafulvalene and its derivatives, conjugated semiconducting polymers or polymer lends, phthalocyanines, porphyrins, acenes and substituted acenes, carbon nanotubes, coordination compounds and organometallic complexes. According to a further embodi ment said acceptor material comprises a material selected from the group consisting of F16CoPc, F16ZnPc, NiTPP, tetracyanoethylene, tetracyanoquinucl idine and its derivatives, fullerenes, polycyclic aromatics, coordination compounds and organometallic complexes. According to a further embodiment said donor material and said acceptor material form a planar rectifying junction, a mixed heterojunction, or a bulk heterojunction.

According to another example useful for understanding the invention, there is disclosed an organic material for use in an organic photosensitive optoelectronic device for detection of infrared rad iation, comprising an organic photoconductive material comprising a host material, a phosphorescent dopant material, and a sensitizer material, wherein said sensitizer material has (i) an exciton energy level within $\Delta E$ below $E_{min}$, wherein $E_{min}$ is the minimum excitation energy for generating charge carriers in said photoconductive organic material and $\Delta E$ is in the infrared region of the electromagnetic spectrum, and (ii) singlet and triplet exciton levels nested in singlet and triplet exciton energy levels of said phosphorescent dopant material, and wherein said triplet exciton energy level of said phosphorescent dopant material is within $\Delta E$ below $E_{min}$.

According to another example useful for understanding the invention, there is disclosed an organic material for use in an organic photosensitive optoelectronic device for detection of infrared radiation, comprising an organic photoconductive material comprising a host material and a phosphorescent dopant material, wherein said host material has (i) an exciton energy level within $\Delta E$ below $\Delta E$ below $E_{min}$, wherein $E_{min}$ is minimum excitation energy for generating charge carriers in said photoconductive organic material and $\Delta E$ is in the infrared region of the electromagnetic spectrum, and (ii) singlet and triplet exciton levels nested in singlet and triplet exciton energy levels of said phosphorescent dopant material, and wherein said triplet exciton energy level E of said phosphorescent dopant material is within $\Delta E$ below $E_{min}$. According to an embodiment $\Delta E$ is in the range of about 0.1 to about 1.7 eV. According to a further embodiment said photoconductive organic material is a donor material, wherein said organic material further comprising an acceptor material in contact with said donor material to form a rectifying junction. According to a further embodiment $E_{min}$ is no less than the LUMO energy of said acceptor material. According to a further embodiment $E_{min}$ is about 50 mV higher than the LUMO energy of said acceptor material. According to a further embodiment said photoconductive organic material is an acceptor material, wherein said acceptor material is in contact with a donor material to form a rectifying junction. According to a further embodiment $E_{min}$ is no higher than the HOMO energy of said acceptor material. According to a further embodiment $E_{min}$ is about 50 mV lower than the HOMO energy of said acceptor material. According to a further embodiment said donor material comprises a material selected from the group consisting of carbazole containing materials, arylamines, tetraarylphenylenediames, oligothiophenes, phenylonevinylenes, oligopyrroles, tetrathiafulvalene and its derivatives, conjugated semiconducting polymers or polymer blends, phthalocyanines, porphyrins, acenes and substituted acenes, carbon nanotubes, coordination compounds and organometallic complexes. According to a further embodiment said acceptor material comprises a material selected from the group consisting of F16CoPc, F16ZnPc, NiTPP, tetracyanoethylene, tetracyanoquinuclid ine and its derivatives, fullerenes, polycyclic aromatics, coordination compounds and organometallic complexes. According to a further embodiment said donor material and said acceptor material form a planar rectifying junction, a mixed heterojunction, or a bulk heterojunction.

According to another example useful for understanding the invention, there is disclosed an imager for imaging infrared radiation, comprising a plurality of the organic photosensitive optoelectronic devices as described before. According to an embodiment said plurality comprises at least 10, 100, 10000 or $10^6$ or more of said organic photosensitive optoelectronic devices. According to a further embodiment each of said organic photosensitive optoelectronic devices is 1$\mu$m x 1 $\mu$m or less in size. According to a further embodiment said plurality of organic photosensitive optoelectronic devices form an individually addressable array.

The present application provides a method of detecting infrared radiation. The method of the invention comprises irradiating a photoconductive organic material with a pump light which has a photon energy suitable to generate in the photoconductive organic material one or more first excitons of energy E, where E is lower than mi nimum excitation energy $E_{min}$ for generating charge carriers in the photoconductive organic material by an energy difference corresponding to the infrared region of the electromagnetic spectrum, exposing the photoconductive organic material to infrared radiation, and detecting charge carriers generated by absorption of the infrared radiation by the first excitons. The method of the present invention can be used to detect near- or mid-infrared radiation having an energy in the range of about 0.1 to about 1.7 eV.

The pump light wavelength is determined based on the photoconductive organic material used, and is generally in the visible and ultraviolet region of the electromagnetic spectrum. The intensity of the pump light is preferably chosen such that a sufficient population of the first excitons is generated to allow sufficient charge generation by the IR for

accurate charge detection.

The pump light is pulsed light.

In a further embodiment, the first excitons are first singlet excitons. The first singlet excitons can be generated by the pump light in the photoconductive organic material by direct singlet-singlet transition. In another embodiment, the pump light generates in the photoconductive organic material one or more higher lying singlet excitons which subsequently convert to the one or more first singlet excitons.

The photoconductive organic material can be a pure material or a mixed material.

The photoconductive organic material comprises a host material and a dopant material.

The dopant material absorbs the pump light to generate the first exciton.

Alternatively, the host material absorbs the pump light to generate an exciton in the host material which then converts to the first exciton in the dopant material.

The photoconductive organic material comprises a host material and a dopant material which serves to promote charge separation. In this embodiment, the absorption of the infrared radiation by the first exciton results in generation of a second exciton which dissociates into charge carriers by relaxation to the LUMO of the dopant material.

In another embodiment, the first excitons are first triplet excitons. Infrared absorption by these triplet excitons results in the generation of higher lying triplet excitons which dissociate into charge carriers. In one embodiment, the pump light generates in the photoconductive organic material one or more singlet excitons which subsequently convert to the one or more first triplet excitons. The first triplet excitons can also be generated by the pump light in the photoconductive organic material by a direct singlet-triplet transition.

In embodiments employing first triplet excitons, the photoconductive organic material can comprise a host material and a phosphorescent dopant material. In a preferred embodiment, the pump light generates in the phosphorescent material one or more singlet excitons which convert to the first triplet excitons in the phosphorescent dopant material, e.g., via intersystem crossing. In another preferred embodiment, the pump light generates in the host material one or more singlet excitons which convert to the first triplet excitons in the phosphorescent dopant material. The conversion can be achieved via direct intersystem crossing from the singlet excitons to the first triplet excitons. The conversion can also be achieved via energy transfer to a singlet exciton in the phosphorescent dopant material followed by intersystem crossing from the singlet excitons in the phosphorescent dopant to the first triplet excitons. Preferably, the singlet excitons convert to the first triplet excitons on a time scale less than the time scale for charge separation. In a specific embodiment, the singlet excitons convert to the first triplet excitons on a time scale less than about 1 picosecond. Such a fast singlet to triplet conversion allows utilizing singlet excitons lying above $E_{min}$ to generate triplet excitons of the appropriate energy.

In another preferred embodiment, a sensitizer is used to enhance the production of the first triplet excitons. In one embodiment, the host material is selected to have singlet and triplet exciton levels nested in singlet and triplet exciton levels of the phosphorescent dopant material. Such a host material therefore serves as the sensitizer.

In another embodiment, the photoconductive organic material comprises a host material, a phosphorescent dopant material and a sensitizer material. The pump light generates in the sensitizer material one or more singlet excitons which convert to the first triplet excitons in the phosphorescent dopant material. Preferably, the sensitizer material has singlet and triplet exciton levels nested in singlet and triplet exciton levels of said phosphorescent dopant material.

The method of the present invention can be carried out using a photoconductive device, whereby carriers generated by the IR are detected by detecting the changes in conductivity or resistance in the photoconductive material.

The method of the present invention can also be carried out using a photovoltaic device including a rectifying junction, whereby carriers generated by the IR are detected by detecting the voltage across the rectifying junction. The rectifying junction can be but is not limited to a planar rectifying junction, a mixed heterojunction, or a bulk heterojunction. In one embodiment, the photoconductive organic material is a donor material, which is used in contact with an acceptor material to form a rectifying junction. In such an embodiment, $E_{min}$ is preferably no less than the LUMO energy of said acceptor material. More preferably, $E_{min}$ is about 50 mV higher than the LUMO energy of said acceptor material.

In another embodiment, the photoconductive organic material is an acceptor material, which is used in contact with a donor material to form a rectifying junction. In such an embodiment, $E_{min}$ is preferably no higher than the HOMO energy of said acceptor material. More preferably, $E_{min}$ is about 50 mV lower than the HOMO energy of said acceptor material.

According to a comparative example not covered by the claims, there is provided an organic photosensitive optoelectronic device for detecting infrared radiation, comprising a first electrode and a second electrode; and a photoconductive organic material of the present invention disposed between the first electrode and the second electrode. The photoconductive organic material can be any of those described above in connection with the method of the invention.

The organic photosensitive optoelectronic device of the comparative example may further comprise a source of visible and/or ultraviolet light disposed so as to illuminate the organic photoconductive material. The intensity of visible and/or ultraviolet light can be selected in a similar manner as described in connection with the method of the invention. The organic photosensitive optoelectronic device of the comparative example may further comprise at least one exciton

blocking layer between the two electrodes and adjacent to at least one of the two electrodes.

According to a further example not covered by the claims, there is provided an organic material for use in an organic photosensitive optoelectronic device for detection of infrared radiation. The organic material can be any of those described above in connection with the method of the invention.

According to a further example not covered by the claims, there is provided an imager for imaging infrared radiation, comprising a plurality of the organic photosensitive optoelectronic devices of the comparative example. The imager of the comparative example preferably has at least 10, 100, 10000, $10^6$ or more organic photosensitive optoelectronic devices. The organic photosensitive optoelectronic devices in the imager of the comparative example can be 1 $\mu$m x 1 $\mu$m or less in size. Preferably, the plurality of organic photosensitive optoelectronic devices in the imager form an individually addressable array.

## Brief Description of the Drawings

The component structures in the devices shown in the following figures are not necessarily drawn to scale:

FIG. 1 presents energy level diagrams showing two-photon excitation via $S_1$ singlet (1A and 1D) and $T_1$ triplet (1B and IC) excited states of a dopant.

FIG. 2 is an energy level diagram illustrating photoinduced exciton formation in either component of a donor-acceptor heterojunction, and dissociation of the exciton into separated charge carriers at the junction.

FIG. 3 illustrates photoinduced exciton formation in a donor, and dissociation of the exciton at the planar heterojunction of a donor-acceptor bilayer.

FIG. 4 illustrates photoinduced exciton formation and dissociation in a mixed heterojunction, sandwiched between a donor layer and an acceptor layer.

FIG. 5 illustrates photoinduced exciton formation, and dissociation in a bulk (non-planar) heterojunction.

FIG. 6 illustrates an organic photosensitive device with an integral light source.

FIG. 7 shows the structures of representative triplet sensitizers.

FIG. 8 shows an energy level diagram illustrating of triplet exciton generation via a sensitizer.

## Detailed Description

As used herein, a first HOMO or LUMO energy level is "greater than" or "higher than" a second HOMO or LUMO energy level if the first energy level is closer to the vacuum energy level. A higher HOMO energy level corresponds to an ionization potential ("IP") having a smaller absolute energy relative to a vacuum level. Similarly, a higher LUMO energy level corresponds to an electron affinity ("EA") having a smaller absolute energy relative to vacuum level. On a conventional energy level diagram, with the vacuum level at the top, the LUMO energy level of a material is higher than the HOMO energy level of the same material.

In the context of organic materials, the terms "donor" and "acceptor" refer to the relative positions of the Highest Occupied Molecular Orbital ("HOMO") and Lowest Unoccupied Molecular Orbital ("LUMO") energy levels of two contacting but different organic materials. Where one material is in contact with another, the material having the lower energy LUMO is the acceptor and the material having the higher-energy LUMO is the donor. It is energetically favorable, in the absence of an external bias, for electrons promoted to the donor LUMO to move into the acceptor material at the donor-acceptor junction. The result is dissociation of the exciton into separated charge carriers, which can be conducted to external circuitry for detection.

Figure 2 is an energy-level schematic representation of a donor-acceptor heterojunction. The absorption of a photon **6** in the donor **152** or the acceptor **154** creates an exciton **8,** which dissociates at the rectifying interface. The donor **152** transports the hole (open circle) and the acceptor **154** transports the electron (dark circle).

Figure 3 illustrates the photogeneration of an exciton in the donor layer of a bilayer heterojunction, the dissociation of the exciton into charge carriers at the planar junction, and conduction of the charge carriers away from the junction.

Figure 4 illustrates the same process taking place in a photoactive planar mixed heterojunction layer **153.** In a planar mixed heterojunction, the donor and acceptor materials are blended at or close to the molecular level, on the

order of a few nanometers or less, and in the case of the hybrid heterojunction shown in Figure 4 the mixed layer is sandwiched between donor and acceptor layers. The concentrations of the components in a mixed layer may increase along a gradient toward the corresponding donor or acceptor layer or electrode.

Figure 5 illustrates the process taking place in a bulk heterojunction, where the photoactive layer is a blend of interpenetrating organic donor and acceptor phases. The phase regions may range in size from a few nanometers to about 100 nanometers in a bulk heterojunction. The heterojunction may be a disordered mixture, or an ordered interpenetrating network of donor and acceptor phases.

As used herein, the term "organic" includes polymeric materials as well as small molecule organic materials that may be used to fabricate organic opto-electronic devices. "Small molecule" refers to any organic material that is not a polymer, and "small molecules" may actually be quite large. Small molecules may include repeat units in some circumstances. For example, using a long chain alkyl group as a substituent does not remove a molecule from the "small molecule" class. Small molecules may also be incorporated into polymers, for example as a pendent group on a polymer backbone or as a part of the backbone. Small molecules may also serve as the core moiety of a dendrimer, which consists of a series of chemical shells built on the core moiety. The core moiety of a dendrimer may be a fluorescent or phosphorescent small molecule emitter. A dendrimer may be a "small molecule." In general, a small molecule has a defined chemical formula with a molecular weight that is the same from molecule to molecule, whereas a polymer has defined element ratios with a molecular weight that may vary from molecule to molecule. As used herein, "organic" includes metal complexes of hydrocarbyl and heteroatom-substituted hydrocarbyl ligands.

As used herein, "near- and mid-IR radiation" refers to radiation having energies between 0.1 and 1.7 eV.

The present application provides a method of detecting infrared radiation. In the method of the invention, a photoconductive organic material is irradiated with a pulsed pump light which has a photon energy suitable to generate in the photoconductive organic material one or more first excitons of energy E, where E is lower than minimum excitation energy conducive for generating charge carriers in the photoconductive organic material by an energy difference in the infrared region of the electromagnetic spectrum. If $\Delta E$ represents the energy difference, and $E_{min}$ represents the minimum excitation energy conducive for generating charge carriers in the photoconductive organic material, then $\Delta E = E_{min} - E$. The photoconductive organic material is exposed to infrared radiation. If the infrared radiation is present, absorption of the infrared radiation by the first excitons results in generation of charge carriers, which are detected. The method of present invention can be used to detect near- or mid-infrared radiation, i.e., $\Delta E$ is in the range of about 0.1 to about 1.7 eV.

The pump light wavelength is determined based on the photoconductive organic material used, and is generally visible and ultraviolet region of the electromagnetic spectrum. The intensity of the pump light is preferably chosen such that a sufficient population of the first excitons is generated. Various factors may affect the selection of pump intensity, including one or more of (a) absorption coefficient of the excited state to the wavelength to be detected, (b) the lifetime of the excited state, (c) the thickness of the device active region (which in turn is dependent on the charge collection efficiency), and (d) expected repetition rate of the incident light to be detected. In one embodiment, the intensity of the pump light is determined based on Equations (1) and (2) below. The number of excitons N generated by a pump power P is given by:

$$N = \frac{P\tau}{E}\frac{\alpha}{R(1-\exp(-\alpha d))} \qquad (1)$$

where $\tau$ = excited state lifetime
$\alpha$=absorption coefficient of the ground to excited state transition
R=reflectivity of the layer
d=layer thickness
E=photon energy

The signal current is then

$$J_{SIG} = qP_{SIG}\frac{R(1-\exp(-\alpha_{SIG}d))}{E_{SIG}} \qquad (2)$$

where the meanings of the symbols are the same as above except that they refer to the signal pulse, of duration t, as opposed to the pump, and the absorption coefficient at the signal wavelength is $\alpha_{SIG}=\alpha_{SIG}(N)$, Therefore, for a given signal current detection method, the desirable pump power P can be determined according to Equations (1) and (2) based on the desired sensitivity of detecting $J_{SIG}$.

The pump light is pulsed light.

The first excitons can be any excitons in the photoconductive organic material which can be generated by the pump light and absorbs the infrared radiation to generate carriers with sufficient efficiencies. The first excitons can be generated by the pump light in the photoconductive organic material by direct transition. The first excitons can also be generated indirectly by the pump light via internal conversion, where absorption of the pump light generates an exciton which converts to the first exciton.

In one embodiment, the first excitons are first singlet excitons. The first singlet excitons can be generated by the pump light in the photoconductive organic material by direct singlet-singlet transition (see e.g., FIG. 1A). In another embodiment, the pump light generates in the photoconductive organic material one or more higher lying singlet excitons which subsequently convert to the one or more first singlet excitons (see e.g., FIG. ID).

Singlet materials suitable for use in this invention include singlet based materials that have high molar absorptivity of visible or UV, a long singlet exciton lifetime and a good transition probability for IR absorption to a higher lying state. Acenes are good candidates for this, with acenes that are sufficiently sterically bulky preferred to prevent aggregation and self quenching. Rubrene is a good example of such a compound. Phenyl or tert-butyl substituted pyrene or perylene are also good candidates.

The photoconductive organic material can be a pure material or a mixed material. In a preferred embodiment, the photoconductive organic material comprises a host material and a dopant material. In one embodiment, the host material and dopant material can be selected such that the dopant material absorbs the pump light to generate the first exciton. In another embodiment, the host material and dopant material can be selected such that the host material absorbs the pump light to generate an exciton in the host material which then generates the first exciton in the dopant material.

In another embodiment, the photoconductive organic material comprises a host material and a dopant material which serves to promote charge separation. In this embodiment, the absorption of the infrared radiation by the first exciton, e.g., in the host material, results in generation of a second exciton which dissociates into charge carriers by relaxation to the LUMO of the dopant material.

In embodiments utilizing a host material and a dopant material, examples of preferred host materials include but are not limited to carbazole containing materials, arylamines, tetraarylphenylenediames, conjugated semiconducting polymers or polymer blends such as poly(phenylene vinylene); phthalocyanines, porphyrins, and transition metal complexes thereof such as CoPc, F16CoPc, F16ZnPc, NiTPP, and the like; fullerenes such as $C_{60}$; polycyclic aromatics such as PTCDA, NTCDA, TCTA, 3,4,9,10-perylenetetracarboxylic acid bis-benzimidazole, and the like; and transition metal, actinide, and lanthanide complexes.

Examples of preferred dopant materials include but are not limited to metallophthalocyamines, metalloporphyrins, aceces, such as anthracene, tetracene and pentacene, substitutes acenes, such as rubrene, and common laser dyes, such as coumarins, fluorescence, rhodamines and others.

The method of the present invention can be carried out using a photoconductive device, whereby carriers generated by the IR are detected by detecting the changes in conductivity or resistance in the photoconductive material.

The method of the present invention can also be carried out using a photovoltaic device including a rectifying junction, whereby carriers generated by the IR are detected by detecting the voltage across the rectifying junction. The rectifying junction can be but is not limited to a planar rectifying junction, a mixed heterojunction, or a bulk heterojunction. In one embodiment, the photoconductive organic material is a donor material, which is used in contact with an acceptor material to form a rectifying junction. In such an embodiment, $E_{min}$ is preferably no less than the LUMO energy of said acceptor material. More preferably, $E_{min}$ is about 50 mV higher than the LUMO energy of said acceptor material.

In another embodiment, the photoconductive organic material is an acceptor material, which is used in contact with a donor material to form a rectifying junction. In such an embodiment, $E_{min}$ is preferably is no higher than the HOMO energy of said acceptor material. More preferably, $E_{min}$ is about 50 mV lower than the HOMO energy of said acceptor material.

In embodiments employing a rectifying junction, suitable donor material include but are not limited to carbazole containing materials, arylamines, tetraarylphenylenediames, oligothiophenes, phenylenevinylenes, oligopyrroles, tetrathiafulvalene, its derivatives and related fulvalene materials, conjugated semiconducting polymers or polymer blends such as poly(phenylene vinylene); phthalocyanines, porphyrins, acenes and substituted acenes, carbon nanotubes, as well as coordination compounds and organometallic complexes with HOMO levels above those of the acceptor materials used in the device, such that they are effective electron donors.

Suitable acceptor material include but are not limited to F16CoPc, F16ZnPc, NiTPP, and the like, tetracyanoethylene, tetracyanoquinuclidine and its derivatives, $C_{60}$, $C_{70}$ and other fullerenes; polycyclic aromatics such as PTCDA, NTCDA, TCTA, 3,4,9,10-perylenetetracarboxylic acid bis-benzimidazole, as well as coordination compounds and organometallic complexes with LUMO levels below those of the donor, such that they are effective electron acceptors.

In another embodiment, the first excitons are first triplet excitons. Infrared absorption by these triplet excitons results in generation of higher lying triplet excitons which dissociate into charge carriers. A triplet excited state has a lifetime orders of magnitude longer than a singlet excited state, markedly increasing the likelihood of absorption of an

IR photon by the triplet excited state. Metalloporphyrins are good examples of the materials that can be used. Preferably, the porphyrin is sterically substituted to prevent aggregation and the self quenching of the triplet state. Porphyrins also have a high molar absorbance for visible light into both the Soret and Q-bands. Preferred examples of porphyrins that can be used in the present invention are Pt and Pd complexes of tetraphenylporphyrin, tetraphenyltetrabenzoporphyrin and related sterically substituted metalloporphyrins. These materials give high ISC efficiency and have triplet lifetimes over 100 microseconds.

Another family of materials that can be used in the present invention is heavy metal containing complexes, particularly those of platinum and iridium. Many of these complexes can be sterically substituted to prevent self quenching, even at very high concentrations. These complexes also have highly efficient ISC. Three Pt complexes are listed in Example 1, which have long triplet lifetimes, even as neat solids. These materials have long triplet lifetimes, in both lightly and heavily doped films (see Table 1 of Example 1). The $T_1$ energy here is based on the phosphorescence energy for thin films. Excitation for these compounds can be accomplished with UV to blue light.

In one embodiment, the pump light generates in the photoconductive organic material one or more singlet excitons which subsequently convert to the one or more first triplet excitons (see e.g., FIG. IB). The first triplet excitons can also be generated by the pump light in the photoconductive organic material by a direct singlet-triplet transition (see e.g., FIG. 1C).

In embodiments employing first triplet excitons, the photoconductive organic material can comprise a host material and a triplet-generating dopant material such as a phosphorescent dopant material. The triplet-generating material can be selected, in part, on the basis that the energy of triplet-triplet absorption commensurate with the energy of the radiation to be detected, a high molar absorptivity, efficient intersystem crossing, a long triplet lifetime, and efficient charge separation in the higher lying triplet state. It will be appreciated that for use in the present invention, efficient light emission from the triplet-generating dopant material is not required. Suitable triplet-generating dopant materials include but are not limited to phosphorescent materials. In the present application, for simplicity reasons, embodiments employing triplet-generating dopant material are often disclosed with reference to phosphorescent materials. However, it is contemplated that such disclosures are equally applicable to other triplet-generating materials.

In a preferred embodiment, the pump light generates in the phosphorescent material one or more singlet excitons which convert to the first triplet excitons in the phosphorescent dopant material, e.g., via intersystem crossing. In another preferred embodiment, the pump light generates in the host material one or more singlet excitons which convert to the first triplet excitons in the phosphorescent dopant material. The conversion can be achieved via direct intersystem crossing from the singlet excitons to the first triplet excitons. In this embodiment, the conversion can also be achieved via energy transfer to a singlet exciton in the phosphorescent dopant material followed by intersystem crossing from the singlet excitons in the phosphorescent dopant to the first triplet excitons. Preferably, the singlet excitons convert to the first triplet excitons on a time scale less than the time scale for charge separation. In a specific embodiment, the singlet excitons convert to the first triplet excitons on a time scale less than about 1 picosecond. Such a fast singlet to triplet conversion allows utilizing singlet excitons lying above $E_{min}$ to generate triplet excitons of the appropriate energy.

Preferred host materials include but are not limited to carbazole containing materials, arylamines, tetraarylphenylenediames, oligothiophenes, phenylenevinylenes, oligopyrroles, tetrathiafulvalene, its derivatives and related fulvalene materials, conjugated semiconducting polymers or polymer blends such as poly(phenylene vinylene); phthalocyanines, porphyrins, acenes and substituted acenes, carbon nanotubes, as well as coordination compounds and organometallic complexes with HOMO levels above those of the acceptor materials used in the device, such that they are effective electron donors.

Preferred phosphorescent dopant materials include but are not limited to metalloporphyrins and phthalocyanines with heavy metal ions, whose atomic number is greater than 40, preferably Pd, Pt, Au; organometallic complexes whose metal ion atomic number is greater than 40, preferably Re, Os, Ir, Pt, Pb, Th, Bi; metal complexes that exhibit strong intersystem crossing that have atomic number less than 40, such as Cu and Mn complexes, organic materials that have intersystem crossing efficiencies greater than 25%, such as ketones and heterocyclic materials. In a more preferred embodiment, an organometallic complexes of Ir or Pt is used as the phosphorescent dopant material.

In another preferred embodiment, a sensitizer is used to enhance the production of the first triplet excitons. In order to have a high optical density of the triplet excited states, a high density of triplet excitons in the solid film is preferable. Forming a triplet excited state in an organic material can be enhanced by triplet sensitization. This process employs a sensitizer material that gives efficient intersystem crossing to a triplet state that is higher in energy than the IR absorbing organic material's triplet. The sensitizer's triplet is transferred to the IR absorbing organic molecule. This process is illustrated in Figure 8. In this embodiment, a key aspect is to select the sensitizer having the appropriate energies. Preferably, the singlet and triplet energies of the sensitizer are between ("nested") the singlet and triplet energies of the IR absorbing organic material. This way the sensitizer can be selectively excited (for example by a tuned laser) to a singlet state, e.g., the $S_1$, which will rapidly intersystem cross to the triplet, which will energy transfer to the triplet levels in the IR absorbing organic material. This energy flow process was reported in a paper published in J. Am. Chem. Soc. (Sudhakar Madhusoodhanan, et. al, JACS, 2003, 125(26), 7796-7797). In this paper, the energy transfer

processes for $(C^N)_2Ir(acac)$ transferring energy to a trimer of fluorine is disclosed. The energy transfer process between $(C^N)_2Ir(acac)$ and polyfluorene is also examined.

Examples of sensitizers for this process include heavy metal containing complexes, e.g., of the type that have been developed for OLED emitters. They have small singlet-triplet gaps and can be prepared with almost any triplet energy desired. In a specific embodiment, (lnp)Pt(dpm) or (btp)Pt(dpm) is used as the sensitizer for a rubrene IR absorbing material. Energy transfer to triplet levels in organics has been demonstrated to be very efficient (see the above referenced JACS paper). The organic material (IR absorber) can be chosen to have a long lived triplet in the solid state, with energy levels matched to the donor or acceptor to make a heterojunction that charge separates form higher lying triplet level(s), i.e. $T_n$. A second example is the combination of $(ppy)_2Ir(acac)$ as a sensitizer for a fluorine oligomer or polymer. The triplet level in the oligomer or polymer has a long lifetime, making it an excellent IR absorber. Oligo and polyfluorenees as well as acenes, such as tetracene or pentacene, can also be used, preferably they being substituted to prevent self quenching.

The sensitizer can also be chosen from organic materials that are known to those of skill in the art to be triplet sensitizers. In one embodiment, organic materials of this type have small energy spacings between the singlet and triplet, and have both $\pi$-$\pi^*$ and n-$\pi^*$ transitions. Examples of triplet sensitizing organic materials include ketones, such as benzoin, benzophenone and thioxanthone. These materials are also excellent sensitizers for the formation of triplet states on oligo and polyfluorene.

In one embodiment, the host material is selected to have singlet and triplet exciton levels nested in singlet and triplet exciton levels of said phosphorescent dopant material. Such a host material therefore serves as the sensitizer. In a specific embodiment, the photoconductive organic material comprises a host material of (lnp)Pt(dpm) or (btp)Pt(dpm), and a phosphorescent dopant material of rubrene.

In another embodiment, the photoconductive organic material comprises a host material, a phosphorescent dopant material and a sensitizer material. The pump light generates in the sensitizer material one or more singlet excitons which convert to the first triplet excitons in the phosphorescent dopant material. Preferably, the sensitizer material has singlet and triplet exciton levels nested in singlet and triplet exciton levels of said phosphorescent dopant material.

An organic photosensitive optoelectronic device for detecting infrared radiation, comprising: a first electrode and a second electrode and a photoconductive organic material of the invention disposed between the first electrode and the second electrode. The device can also comprise a source of visible and/or ultraviolet light disposed so as to illuminate the organic photoconductive material. In one embodiment, the device also comprises at least one exciton blocking layer between the two electrodes and adjacent to at least one of the two electrodes.

An organic photosensitive device comprises at least one photoactive region in which light is absorbed to form an exciton, which may subsequently dissociate into an electron and a hole. In Fig. 2, the photoactive region comprises a donor material 152 and an acceptor material 154. Organic materials for use in the photoactive region may include organometallic compounds, including cyclometallated organometallic compounds. The term "organometallic" as used herein is as generally understood by one of ordinary skill in the art and as given, for example, in "Inorganic Chemistry" (2nd Edition) by Gary L. Miessler and Donald A. Tarr, Prentice Hall (1998). Thus, the term organometallic refers to compounds which have an organic group bonded to a metal through a carbon-metal bond. This class does not include per se coordination compounds, which are substances having only donor bonds from heteroatoms, such as metal complexes of amines, halides, pseudohalides (CN, etc.), and the like. In practice organometallic compounds generally comprise, in addition to one or more carbon-metal bonds to an organic species, one or more donor bonds from a heteroatom. The carbon-metal bond to an organic species refers to a direct bond between a metal and a carbon atom of an organic group, such as phenyl, alkyl, alkenyl, etc., but does not refer to a metal bond to an "inorganic carbon," such as the carbon of CN or CO. Preferably the metal is a transition metal, actinide, or lanthanide. Heavy metals are particularly preferred, i.e. those in periods 5-7 of the periodic table. There are a large number of suitable organometallic complexes known in the art which have triplet energy levels of suitable energies for use in the present invention.

The terms "electrode" and "contact" are used interchangeably herein to refer to a layer that provides a medium for delivering photo-generated current to an external circuit or providing a bias current or voltage to the device. Electrodes may be composed of metals or "metal substitutes." Herein the term "metal" is used to embrace both materials composed of an elementally pure metal, and also metal alloys which are materials composed of two or more elementally pure metals. The term "metal substitute" refers to a material that is not a metal within the normal definition, but which has the metal-like properties such as conductivity, such as doped wide-bandgap semiconductors, degenerate semiconductors, conducting oxides, and conductive polymers. Electrodes may comprise a single layer or multiple layers (a "compound" electrode), may be transparent, semi-transparent, or opaque. Examples of electrodes and electrode materials include those disclosed in U.S. Patent No. 6,352,777 to Bulovic et al., and U.S. Patent No. 6,420,031, to Parthasarathy, et al.. As used herein, a layer is said to be "transparent" to a given wavelength of electromagnetic radiation if it transmits at least 50% of electromagnetic radiation having that wavelength, and "partially transparent" if it transmits between 20% and 50% of that radiation.

The substrate may be any suitable substrate that provides desired structural properties. The substrate may be

flexible or rigid, planar or non-planar. The substrate may be transparent, translucent or opaque. Rigid plastics and glass are examples of preferred rigid substrate materials. Flexible plastics and metal foils are examples of preferred flexible substrate materials.

An anode-smoothing layer may be situated between the anode layer and the donor layer. Anode-smoothing layers are described in U.S. Patent 6,657,378 to Forrest et al..

Unless otherwise specified, any of the layers of the various embodiments may be deposited by any suitable method. For the organic layers, preferred methods include thermal evaporation, ink-jet, such as described in U.S. Patent Nos. 6,013,982 and 6,087,196, organic vapor phase deposition (OVPD), such as described in U.S. Patent No. 6,337,102 to Forrest et al., and deposition by organic vapor jet printing (OVJP), such as described in U.S. Patent Application No. 10/233,470. Other suitable deposition methods include spin coating and other solution based processes. Solution based processes are preferably carried out in nitrogen or an inert atmosphere. For the other layers, preferred methods include thermal evaporation. Preferred patterning methods include deposition through a mask, cold welding such as described in U.S. Patent Nos. 6,294,398 and 6,468,819, and patterning associated with some of the deposition methods such as ink-jet and OVJD. Other methods may also be used. The materials to be deposited may be modified to make them compatible with a particular deposition method. For example, substituents such as alkyl and aryl groups, branched or unbranched, and preferably containing at least 3 carbons, may be used in small molecules to enhance their ability to undergo solution processing. Substituents having 20 carbons or more may be used, but 3-20 carbons is the preferred range. Materials with asymmetric structures may have better solution processability than those having symmetric structures, because asymmetric materials may have a lower tendency to recrystallize. Dendrimer substituents may be used to enhance the ability of small molecules to undergo solution processing.

How to pair two organic photoconductive materials to serve as a donor and an acceptor in a photovoltaic heterojunction based upon carrier mobilities and relative HOMO and LUMO levels is well-known in the art, and is not addressed here.

Examples of various types of donor-acceptor heterojunctions are shown in Figures 3-5. Fig. 3 illustrates a donor-acceptor bilayer forming a planar heterojunction. Fig. 4 illustrates a hybrid heterojunction including a mixed heterojunction **153** comprising a mixture of donor and acceptor materials arranged between the donor material **152** and the acceptor material **154.** Fig. 5 illustrates an idealized "bulk" heterojunction. A bulk heterojunction, in the ideal photocurrent case, has a single continuous interface between the donor material **252** and the acceptor material **254,** although multiple interfaces typically exist in actual devices. Mixed and bulk heterojunctions can have multiple donor-acceptor interfaces as a result of having plural domains of material. Domains that are surrounded by the opposite-type material (e.g., a domain of donor material surrounded by acceptor material) may be electrically isolated, such that these domains do not contribute to photocurrent. Other domains may be connected by percolation pathways (continuous photocurrent pathways), such that these other domains may contribute to photocurrent. The distinction between a mixed and a bulk heterojunction lies in degrees of phase separation between donor and acceptor materials. In a mixed heterojunction, there is very little or no phase separation (the domains are very small, *e.g.,* less than a few nanometers), whereas in a bulk heterojunction, there is significant phase separation (*e.g.*, forming domains with sizes of a few nanometers to 100 nm).

Small-molecule mixed heterojunctions may be formed, for example, by codeposition of the donor and acceptor materials using vacuum deposition or vapor deposition. Small-molecule bulk heterojunctions may be formed, for example, by controlled growth, codeposition with post-deposition annealing, or solution processing. Polymer mixed or bulk heterojunctions may be formed, for example, by solution processing of polymer blends of donor and acceptor materials.

If a photoactive region includes a mixed layer (**153**) or bulk layers (**252**, **254**) and one or both of the donor (**152**) and acceptor layers (**154**), the photoactive region is said to include a "hybrid" heterojunction. The arrangement of layers in Fig. 4 is an example. For additional explanation of hybrid heterojunctions, published U.S. Patent Application 2005/0224113, entitled "High efficiency organic photovoltaic cells employing hybridized mixed-planar heterojunctions" by Jiangeng Xue *et al.,* published October 13, 2005.

In general, planar heterojunctions have good carrier conduction, but poor exciton dissociation; a mixed layer has poor carrier conduction and good exciton dissociation, and a bulk heterojunction has good carrier conduction and good exciton dissociation, but may experience charge build-up at the end of the material "cul-de-sacs," lowering efficiency. Unless otherwise stated, planar, mixed, bulk, and hybrid heterojunctions may be used interchangeably as donor-acceptor heterojunctions throughout the embodiments disclosed herein.

The donor material has an ionization potential that is smaller than that of the acceptor material. Further, the ionization potential HOMO/LUMO gap of the donor layer must be smaller than that of the acceptor layer. Generally, the materials comprising the donor or acceptor layers should have long exciton diffusion length, and thus are preferably those materials which lend themselves to ordered stacking of the molecules, such as planar, aromatic molecules.

The acceptor material may comprise, for example, perylenes, naphthalenes, fullerenes or nanotubules. A suitable acceptor material is 3,4,9,10-perylenetetracarboxylic bis-benzimidazole (PTCBI). Alternatively, the acceptor layer may be comprised of a fullerene material as described in the U.S. Pat. No. 6,580,027.

Adjacent to the acceptor layer, is a layer of organic donor-type material. The boundary of the acceptor layer

and the donor layer forms a heterojunction which may produce an internally generated electric field. The photoconductive organic materials of the present invention may be any of the materials known in the art to generate excitons upon irradiation with visible or ultraviolet light. Suitable materials for the donor and acceptor component include, but are not limited to, conjugated semiconducting polymers or polymer blends such as poly(phenylene vinylene); phthalocyanines, porphyrins, and transition metal complexes thereof such as CoPc, F16CoPc, F16ZnPc, NiTPP, and the like; C60; polycyclic aromatics such as PTCDA, NTCDA, TCTA, 3,4,9, 10-perylenetetracarboxylic acid bis-benzimidazole, and the like, and transition metal, actinide, and lanthanide complexes, e.g., $Ru(bpy)_3^{2+}$ complexes and the like.

In certain embodiments, the active region comprises multiple subcells, i.e. it is an alternating donor-acceptor multilayer stack. It is preferred that the alternating donor layers and acceptor layers be thin layers in order to allow charge tunneling. It will be understood that all photoactive layers will preferably have a thickness that is at least on the order of the IR radiation to be detected, more preferably several or many wavelengths thick.

The devices, as illustrated in Fig. 6, may be connected to an element 607, which is a current- or voltage-detecting circuit which measures the current or voltage generated when the photodetector is exposed to light, and which may apply a bias to the device (as described for example in Published U.S. Patent Application 2005/0110007, published May 26, 2005 to Forrest et al.). If the rectifying junction is eliminated from the device (e.g., using a single photoconductive material as the photoactive region), the resulting structures may be used as a photoconductor cell, in which case the element **607** is a signal detection circuit to monitor changes in resistance across the device due to the absorption of light. Unless otherwise stated, each of these arrangements and modifications may be used for the embodiments disclosed herein.

An organic photosensitive device may also comprise transparent charge transfer layers, electrodes, or charge recombination zones. A charge transfer layer may be organic or inorganic, and may or may not be photoconductively active. A charge transfer layer is similar to an electrode, but does not have an electrical connection external to the device and only delivers charge carriers from one subsection of a device to the adjacent subsection. A charge recombination zone is similar to a charge transfer layer, but allows for the recombination of electrons and holes between adjacent subsections of tandem photosensitive devices. A charge recombination zone may include semi-transparent metal or metal substitute recombination centers comprising nanoclusters, nanoparticles, and/or nanorods, as described for example in U.S. Patent No. 6,657,378 to Forrest et al.*;* Published U.S. Patent Application 2006-0032529 A1, entitled "Organic Photosensitive Devices" by Rand *et al.,* published February 16, 2006; and Published U.S. Patent Application 2006-0027802 A1, entitled "Stacked Organic Photosensitive Devices" by Forrest *et al.,* published February 9, 2006. A charge recombination zone may or may not include a transparent matrix layer in which the recombination centers are embedded. A charge transfer layer, electrode, or charge recombination zone may serve as a cathode and/or an anode of subsections of the device. An electrode or charge transfer layer may serve as a Schottky contact.

Examples of electrodes used in organic photosensitive devices are shown in U.S. Patent No. 6,352,777. When used herein, the term "electrode" refers to a conductive layer that provides a medium for delivering photogenerated charge carriers to an external circuit, and for providing any bias voltage to the device. That is, an electrode provides the interface between the photoactive regions of the device and a wire, lead, trace or other means for transporting the charge carriers to or from the external circuit.

In a photosensitive device, it is desirable to allow the maximum amount of ambient electromagnetic radiation from the device exterior to be admitted to the photoactive interior region. That is, the electromagnetic radiation must reach a photoactive layer, where it can generate the excitons that give rise to charge carriers. This often dictates that preferably, at least one of the electrodes should be minimally absorbing and minimally reflecting of the incident electromagnetic radiation. That is, such an electrode should be substantially transparent. The opposing electrode may be transparent as well, or it may be reflective so that light which has passed through the cell without being absorbed is reflected back through the cell. As used herein, a layer of material or a sequence of layers of different materials is said to be "transparent" when the layer or layers permit at least 50% of the ambient electromagnetic radiation in relevant wavelengths to be transmitted through the layer or layers.

The organic photosensitive devices may include, as one or more of the transparent electrodes of the photosensitive device, a highly transparent, non-metallic, low resistance cathode such as disclosed in U.S. Patent Application Serial No. 09/054,707 to Parthasarathy et al., or a highly efficient, low resistance metallic/non-metallic compound cathode such as disclosed in U.S. Patent No. 5,703,436 to Forrest et al. ("Forrest '436"). Each type of cathode is preferably prepared in a fabrication process that includes the step of sputter depositing an ITO layer onto either an organic material, such as CuPc, to form a highly transparent, non-metallic, low resistance cathode or onto a thin Mg:Ag layer to form a highly efficient, low resistance metallic/non-metallic compound cathode. Parthasarathy et al. disclose that an ITO layer onto which an organic layer had been deposited, instead of an organic layer onto which the ITO layer had been deposited, does not function as an efficient cathode.

In each of the devices described above, layers may be added, such as reflective layers or additional photoactive regions. The order of layers may be altered or inverted. A concentrator or trapping configuration may be employed to increase efficiency, as disclosed, for example in U.S. Patent No. 6,333,458 to Forrest et al. and U.S. Patent No. 6,440,769

to Peumans et al.. Coatings may be used to focus optical energy into desired regions of a device, as disclosed, for example in published US Patent Application No. 2005/0266218 of Peumans et al., published December 1, 2005. In the tandem devices, transparent insulative layers may be formed between cells, with the electrical connection between the cells being provided via electrodes. Also in the tandem devices, one or more of the photoactive regions may be a Schottky-barrier heterojunction instead of a donor-acceptor heterojunction. Arrangements other than those specifically described, such as for example recombination zones deployed between the cells, may be used.

The photoactive regions of the detectors comprise a photoconductive organic material. In operation, this photoactive material is first excited with a pulse of high-energy radiation (e.g. from a flash lamp or diode laser), having sufficient energy to produce excitons in an $S_1$ state. During the lifetime of the excitons, the photoactive region is then exposed to the near- or mid-IR radiation which is to be detected. It will be appreciated that the lifetime of singlet excitons is typically very short, and that suitably short pulses and fast circuitry will be employed in operating these detectors. While not energetic enough to excite the ground-state photoconductive material to the $S_1$ state, the mid- or near-IR radiation is sufficiently energetic to raise $S_1$ excitons to a higher but more closely-spaced level, typically an $S_2$ or LUMO state.

Absorption of infrared radiation typically excites vibrational modes in organic materials. Electronic excitation is rare because the energy gap between HOMO and LUMO in organic materials is typically large, and formation of an exciton requires a photon in the visible or ultraviolet region of the spectrum to induce an $S_0$ to $S_1$ transition. The detectors take advantage of the electronic energy levels between excited states in a semiconductor or dopant, which are more closely spaced than the $S_0$ - $S_1$ gap. A molecule is pumped to an excited state by an initial UV or visible light pulse, and the excited state, because of the closely spaced excited states, serves as the IR-absorbing species. In preferred embodiments, the IR radiation is near- and mid-IR radiation.

Detection of charge carriers derived from the dissociation of the resulting higher-energy excitons then provides a measurement of the IR intensity. The photoconductive organic host material is doped so as to provide a route for the relaxation and dissociation of the $S_2$ or LUMO excitons into their constituent charges, and to enable collection and detection of the charges. The photoconductive organic host material can be chosen, in part, on the basis that the accessible $S_2$ or LUMO levels are separated from the $S_1$ state by a gap corresponding to the energy of the radiation to be detected. The dopant can be selected, in part, on the basis that the energy level of the dopant LUMO is lower than the energy level of the host material $S_2$ or LUMO excitons. Suitable materials include, but are not limited to, rubrene and phenyl or tert-butyl substituted pyrene, perylene, and acenes (e.g. tetracene and pentacene).

In another alternative embodiment, irradiation of the photoconductive material generates a singlet state exciton of higher energy than the IR absorbing singlet state exciton, and energy transfers from the singlet state exciton of higher energy to the IR absorbing singlet state exciton. Irradiation of the IR absorbing singlet state exciton with the near- or mid-infrared radiation to be detected converts at least one of these excitons to singlet state exciton having sufficient energy to dissociate into charges (see e.g., Fig. ID). The higher-energy singlet state exciton then dissociates, and the charges generated are detected as described above.

In a preferred embodiment, inconveniences arising from the short lifetime of the singlet state excitons are reduced by employing a triplet-generating material. After irradiation by the visible or UV pulse, intersystem crossing from the singlet state to a longer-lived triplet state (e.g., $T_1$) in the triplet-generating material takes place. During the lifetime of the triplet state excitons, they are exposed to the near- or mid-IR radiation to be detected, which excites them to a higher triplet (e.g., $T_2$) state. As with the singlet embodiments described above, these higher-energy triplet excitons relax by dissociation, e.g., at a heterojunction, with subsequent detection of the charges thereby produced. The triplet-generating material can be selected, in part, on the basis that the higher lying triplet energy levels from the energy level of the triplet state exciton generated by the pump light by a gap commensurate with the energy of the radiation to be detected. Preferred materials will have a high molar absorptivity, efficient intersystem crossing, a long triplet lifetime, and efficient charge separation in the higher lying triplet state. Suitable materials include, but are not limited to, sterically hindered metalloporphyrins, particularly Pd and Pt complexes of tetraphenylporphyrin, tetraphenyltetrabenzoporphyrin, and the like.

Suitable are cyclometallated Pt and Ir diketonate complexes; representative examples of which are shown in Figure 7.

Figure 6 illustrates, by way of example, a device which incorporates a solid-state high-energy light source **601** as an optical pump, which may be, for example, a light-emitting diode or a laser diode. Particularly preferred as a light source are injection laser diodes. The light source will be selected so as to adequately match the emitted radiation to the absorbance spectrum of the host material or dopant for the desired initial $S_0$ to $S_1$ transition. In this embodiment, light from the source **601** passes through a transparent insulating layer **602** and transparent electrode **603** (which may be an anode or cathode) and into the doped semiconductor layer **604,** where the photons are absorbed and $S_1$ state excitons are created. These $S_1$ state excitons transfer energy to the dopant, creating an exciton which undergoes intersystem crossing to create a relatively long-lived $T_1$ exciton. Interaction with infrared radiation, if any is present to be detected, promotes the dopant $T_1$ excitons to a $T_2$ (or higher) state, which is higher in energy than the LUMO of the

acceptor component of the heterojunction. Migration of the triplet exciton to the heterojunction with layer **605** is followed by charge separation at the junction, and, by means well-known in the art, the charges are then conducted via electrodes **603** and **606** to the detector circuit **607.** In other embodiments, layers **604** and **605** are combined into a mixed or bulk heterojunction. Electrode **606** may be transparent to infrared radiation, and serve as the detector window.

External circuitry may be employed to pulse the source **601,** and to sample output from detector **607,** at a frequency appropriate to the lifetimes of the relevant excited states.

In alternative embodiments, layer 605 may be doped with the same or a different dopant, or multiple dopants may be employed in either or both layers in order to take advantage of a broader range of incident wavelengths.

The photoconductive organic material contains a dopant into which the host excitons may transfer. Any of the dopants known in the art to be suitable for use with the photoconductive material may be employed. Suitable materials include, but are not limited to, $Zn(BTZ)_2$, DPVBi, BCzVBi, NPAFN, indeno[1,2,3-cd]perylene, and the like. The amount of dopant will typically be less than about 15% relative to the host material, on a weight basis. Preferably the dopant is present at a level of 2-10%.

The dopant may be a material which, upon irradiation with visible or ultraviolet light, or upon energy transfer from a singlet exciton, undergoes intersystem crossing to yield a triplet $T_1$ state. Particularly preferred are metalloporphyrins and organometallic iridium complexes, such as are known in the art to be useful as emitters in organic light-emitting diodes (OLEDs). Because of the utility of phosphorescent dopants in the manufacture of OLEDs, many such materials are known to those of skill in the art. See, for example, Baldo et al., "Highly Efficient Phosphorescent Emission from Organic Electroluminescent Devices," Nature, vol. 395, 151-154, 1998; and Baldo et al., "Very high-efficiency green organic light-emitting devices based on electrophosphorescence," Appl. Phys. Lett., vol. 75, No. 1, 4-6 (1999). Other representative phosphorescent dopants are disclosed in U.S. Patent Nos. 6,303,238, 6,310,360, 6,830,828, 6,939,624, and 6,835,469; and in Patent Application Publication Nos. WO 02/074015 and US 2008/0061681, see also "Organic Light-Emitting Devices: Synthesis, Properties and Applications" K. Mullen and U. Scherf, eds. (Wiley-VCH, Weinheim, Germany, 2006); and R.C. Evans, P. Douglas and C.J. Winscom, Coordination Chem. Rev., vol. 250(15-16), 2093-2126 (2006). It will be appreciated that for use in the present invention, efficient light emission is not a criterion, and preferred dopants will be those which more efficiently undergo dissociation of the triplet excitons into component charges. Suitable examples include, but are not limited to, $Ir(ppy)_3$, $Ir(bim)_2acac$, $Ir(btb)_2acac$, $Ir(piq)_2(acac)$, and the like.

In alternative embodiments, a triplet sensitizer is employed to convert the pumping radiation into a triplet state exciton, which upon energy transfer to the host material (or to an added dopant) directly produces a long-lived, IR-absorbing $T_1$ state. The sensitizer may have singlet and triplet energies between the singlet and triplet energies of the host material, so that it can be selectively pumped to the $S_1$ state. Intersystem crossing then yields the $T_1$ triplet state. Suitable sensitizers include, but are not limited to, aryl ketones such as benzoin, benzophenone, thioxanthone, and the like; heavy metal complexes such as the cyclometallated iridium complexes FP, PPY, BT, PQ, BTP, and the like; and platinum complexes such as (1-np)Pt(dpm) and (btp)Pt(dpm). (See Fig. 7.) The organic host or dopant to which the sensitizer $T_1$ state transfers energy can be chosen to have a long lived triplet. The energy levels can be matched to the heterojunction donor-acceptor pair so that charge separation takes place from the higher $T_n$ levels produced by absorption of IR radiation. Suitable materials include oligo- and poly-(9,9-dialkylfluorenyl-2,7-diyl), rubrene, tetracene, pentacene, hexacene, and the like. Suitable sensitizers and methods for selecting them are disclosed in P. Djurovich et al., Dalton Trans., 2007, 3763-3770 and M. Sudhakar et al., J. Am. Chem. Soc. 2003, 125: 7796-7797.

The IR-sensitive photodetector devices may be manufactured on small scale, e.g., 1 $\mu$m x 1 $\mu$m or less in size, for use in focal plane arrays suitable for infrared imaging applications. Therefore, an imager is provided for imaging infrared radiation, comprising a plurality of the organic photosensitive optoelectronic devices as described above. The plurality of organic photosensitive optoelectronic devices can comprise at least 10, 100, 10000 or $10^6$ or more of the organic photosensitive optoelectronic devices. In a preferred embodiment, the plurality of organic photosensitive optoelectronic devices forms an array. Preferably, each device in the array is individually addressable. By way of example, the imager may be incorporated into satellite- and aircraft-borne reconnaissance and weapons-targeting cameras, night vision goggles, gunsights, videocameras, security cameras, amateur telescopes, digital cameras, manufacturing line monitors, medical imaging, remote sensing equipment, and night vision systems for automobiles, trucks, and buses. In addition to imaging applications, the detectors of the invention are expected to be stable and amenable to calibration, and may be employed in instruments such as pyrometers, infrared thermometers, and infrared line scanning systems.

## Examples

The following examples are presented to illustrate the methods of the present invention, and are not intended to limit the invention in any way.

Example 1:Detection of Infrared Radiation Using a Singlet Based Material

This example demonstrates detection of infrared radiation in rubrene. Rubrene exhibits high molar absorptivity in the blue region of visible around 2.5 eV, a long $S_1$ lifetime and a good transition probability for NIR conversion to the $S_2$ state around 4 eV. It is also sufficiently sterically bulky which prevents aggregation and self quenching.

Photoconductive cells containing an ITO cathode layer, a LiF:Al anode layer and a thin film of rubrene are fabricated on ITO coated glass substrate by depositing via thermal evaporation a layer of 50 nm of rubrene, followed by depositing a 5nm layer of LiF and 100 nm Al.

The absorption of the photoconductive cells is measured. The photoconductive cell is illuminated from the glass side by two independent radiation sources, a visible pump light tuned to 450 nm, and a near-infrared radiation of wavelength of 750 nm. The relative timing of the visible and IR pulses is adjustable, allowing studying the effect of the delay between the IR and the visible on IR absorption and charge generation. No absorption of the infrared radiation is detected when the pump light is switched off, confirming that the infrared radiation is not sufficient to excite excitons in these materials. When the visible pump light is turned on, absorption of the infrared radiation is detected when the visible and IR overlap in time, but is not detected when the delay between the IR and the visible is longer than 100 nanoseconds. The results demonstrate IR absorption via $S_1$ state of rubrene.

Electrical resistance of the film is also measured. A decrease in resistance is observed to correlate with IR absorption.

Similar measurements are performed with the photoconductive cells containing a layer of poly(phenylene vinylene) (PPV) doped with 10% of rubrene instead of neat rubrene layer. Similar results are obtained.

Photoconductive cells containing an ITO cathode layer, $C_{60}$ (50 nm), a thin film of poly(phenylene vinylene) (PPV) doped with 10% of rubrene (50 nm), and a LiF:Al anode (5 nm LiF:100 nm Al) layer is fabricated on glass substrates. The voltage across the electrodes and its IR absorption are measured are measured as a function of the delay between the IR and the visible.

Example 2 Detection of Infrared Radiation Using a Triplet Based Material

This example demonstrates detection of infrared radiation in a triplet based material.

Photoconductive cells containing an ITO cathode layer, a LiF:Al anode layer and a thin film of poly(phenylene vinylene) (PPV) doped with about 10% of Pt tetraphenylporphyrin (PtTPP) are fabricated on ITO coated glass substrate by thermal co-evaporation of the precursor for PPV and PtTPP in a ultrahigh vacuum to produce a layer of 50 nm of PPV: PtTPP on ITO, followed by deposition of a 5nm layer of LiF and 100 nm Al.

The absorption of the photoconductive cells is first measured. The photoconductive cell is illuminated from the glass side by two independent radiation sources, a visible pump light tuned to 400 nm, and a near-infrared radiation of wavelength of 750 nm. The relative timing of the visible and IR pulses is adjustable, allowing studying the effect of the delay between the IR and the visible on IR absorption and charge generation. No absorption of the infrared radiation is detected when the pump light is switched off, confirming that the infrared radiation is not sufficient to excite excitons in these materials. When visible pump light is turned on, and the visible and IR overlap in time, absorption of the infrared radiation is detected. The effect of time delay between the pump light and IR on IR absorption is also investigated. It is observed that IR absorption decreases as the delay between the IR and visible increases with a half-life of about 100 μs.

Electrical resistance of the film is also measured. A decrease in resistance is observed to correlate with IR absorption.

Similar measurements are performed with photoconductive cells containing PPV doped with about 10% of the following three Pt complexes (dpm = dipivolylmethane (bis-*t*Bu-acac, which have very long triplet lifetimes, even as neat solids). These three Pt complexes have long triplet lifetimes, in both lightly and heavily doped films. The $T_1$ energy here is based on the phosphorescence energy for thin films. Excitation for these compounds can be accomplished with UV to blue light.

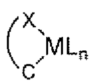
general form

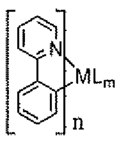
ppy

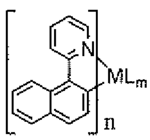
1np

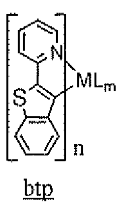
btp

M = Ir, Pt, Os, Au, etc.; L = ancilary ligand
X = N, O, P, S, etc.; n = 1-3; m = 0-4

Table 1 Excited state lifetimes for thin films

| Cpd | τ at RT (μs) | $T_1$ energy (nm) |
|---|---|---|
| (ppy)Pt(dpm) | 6.1 | 477 |
| (1np)Pt(dpm) | 4.9 | 570 |
| (btp)Pt(dpm) | 8.7 | 600 |

The results are consistent with those obtained with PtTPP-doped film.

Example 3 Detection of Infrared Radiation Using a Triplet Based Material and a Sensitizer

Photoconductive cells containing electrodes and a thin film of poly(phenylene vinylene) (PPV) doped with about 10% of fluorine oligomer $F_3$ with or without about 10% of $(ppy)_2Ir(acac)$ as a sensitizer. The cells are fabricated by thermal co-evaporation of the precursor for PPV, $F_3$ with or without $(ppy)_2Ir(acac)$ to form a layer of 50 nm of PPV:$F_3$ or PPV:$(ppy)_2Ir(acac)$:$F_3$ on ITO, followed by depositing a 5nm layer of LiF and 100 nm Al. $F_3$ is estimated to have a triplet energy roughly about 540-580 nm. In addition, $F_3$ has negligible absorption in the region where the phosphors absorb strongly (i.e., 435 nm), allowing the direct excitation of the phosphor.

The absorption of the photoconductive cells is first measured. The photoconductive cell is illuminated from the glass side by two independent radiation sources, a visible pump light tuned to 435 nm, and a near-infrared radiation of wavelength of 750 nm. The relative timing of the visible and IR pulses is adjustable, allowing studying the effect of the delay between the IR and the visible on IR absorption and charge generation. No absorption of the infrared radiation is detected when the pump light is switched off, confirming that the infrared radiation is not sufficient to excite excitons in these materials. When visible pump light is turned on, and the visible and IR overlap in time, absorption of the infrared radiation is detected. The IR absorption is higher in films with $(ppy)_2Ir(acac)$ as compared to film without $(ppy)_2Ir(acac)$, demonstrating enhancement of intersystem crossing as a result of the inclusion of the sensitizer.

Electrical resistance of the film is also measured. A decrease in resistance is observed to correlate with IR absorption.

**Claims**

1. A method of detecting infrared radiation, comprising:

   (i) irradiating a photoconductive organic material comprising a host material and a dopant material with a pump light having a photon energy suitable for generating in said photoconductive organic material one or more first excitons having an energy level E that is within $\Delta E$below $E_{min}$, wherein $E_{min}$ is the minimum excitation energy for generating charge carriers in said photoconductive organic material and $\Delta E$ is in the infrared region of the electromagnetic spectrum;
   (ii) exposing said photoconductive organic material to said infrared radiation, wherein absorption of said infrared radiation by said first exciton results in generation of charge carriers; and
   (iii) detecting said generated charge carriers;
   and either
   wherein said dopant material absorbs said pump light to generate said first exciton, **characterized in that** the pump light is pulsed;
   or
   **characterized in that** the pump light is pulsed light and said host material absorbs said pump light to generate an exciton in said host material which converts to said first exciton in said dopant material.

2. The method of claim 1, wherein said one or more first excitons are singlet excitons.

3. The method of claim 1 or 2, wherein said host material is selected from the group consisting of carbazole containing materials, arylamines, tetraarylphenylenediames, conjugated semiconducting polymers or polymer blends, phthalocyanines, porphyrins, transition metal complexes, $C_{60}$, polycyclic aromatics, and transition metal, actinide, and lanthanide complexes, and/or said dopant material is selected from the group consisting of metallophthalocyanines, metalloporphyrins, acenes, substituted acenes, and laser dyes.

4. The method of any one of the preceding claims, wherein absorption of said infrared radiation by said first exciton results in generation of a second exciton which dissociates into charge carriers by relaxation to the LUMO of said dopant material.

5. The method of claim 1, wherein said one or more first excitons are triplet excitons.

## Patentansprüche

1. Verfahren zum Erfassen von Infrarotstrahlung, folgendes umfassend:

   (i) Bestrahlen eines fotoleitfähigen organischen Materials, das ein Wirtsmaterial und ein Dotiermaterial umfasst, mit einem Pumplicht mit einer Photonenenergie, die geeignet ist, um in dem fotoleitfähigen organischen Material ein oder mehrere erste Exzitonen mit einem Energieniveau E zu erzeugen, das innerhalb von $\Delta E$ unterhalb von $E_{min}$ ist, wobei $E_{min}$ die minimale Anregungsenergie zum Erzeugen von Ladungsträgern in dem fotoleitfähigen organischen Material ist und $\Delta E$ in dem Infrarotbereich des elektromagnetischen Spektrums ist;
   (ii) Aussetzen des fotoleitfähigen organischen Materials der Infrarotstrahlung, wobei ein Absorbieren der Infrarotstrahlung durch das erste Exziton in dem Erzeugen von Ladungsträgern resultiert; und
   (iii) Erfassen der erzeugten Ladungsträger; und

   entweder wobei das Dotierungsmaterial das Pumplicht absorbiert, um das erste Exziton zu erzeugen, **dadurch gekennzeichnet, dass** das Pumplicht gepulst ist; oder
   **dadurch gekennzeichnet, dass** das Pumplicht gepulstes Licht ist und das Wirtsmaterial das Pumplicht absorbiert, um ein Exziton in dem Wirtsmaterial zu erzeugen, das sich in das erste Exziton in dem Dotiermaterial umwandelt.

2. Verfahren nach Anspruch 1, wobei der eine oder die mehreren ersten Exzitonen Singulett-Exzitonen sind.

3. Verfahren nach Anspruch 1 oder 2, wobei das Wirtsmaterial ausgewählt ist aus der Gruppe bestehend aus carbazolhaltigen Materialien, Arylaminen, Tetraarylphenylendiaminen, konjugierten halbleitenden Polymeren oder Polymermischungen, Phthalocyaninen, Porphyrinen, Übergangsmetallkomplexen, $C_{60}$, polycyclischen Aromaten und Übergangsmetall-, Actinid- und Lanthanid-Komplexen, und/oder das Dotierungsmaterial ausgewählt ist aus der Gruppe bestehend aus Metallophthalocyaninen, Metalloporphyrinen, Acenen, substituierten Acenen und Laserfarbstoffen.

4. Verfahren nach einem der vorhergehenden Ansprüche, wobei das Absorbieren der Infrarotstrahlung durch das erste Exziton in einem Erzeugen eines zweiten Exzitons resultiert, das durch Relaxation an dem LUMO des Dotierungsmaterials in Ladungsträger zerfällt.

5. Verfahren nach Anspruch 1, wobei die eine oder mehreren ersten Exzitonen Triplett-Exzitonen sind.

## Revendications

1. Un procédé pour détecter un rayonnement infrarouge, comprenant :

   (i) le fait d'irradier une matière organique photoconductrice comprenant un matériau hôte et un matériau dopant avec une lumière de pompage ayant une énergie photonique appropriée pour générer dans ledit matériau organique photoconducteur un ou plusieurs premiers excitons ayant un niveau d'énergie E qui est à l'intérieur de $\Delta E$ inférieur à $E_{min}$, où $E_{min}$ est l'énergie d'excitation minimale pour générer des porteurs de charge dans ledit matériau organique photoconducteur et $\Delta E$ est dans la zone infrarouge du spectre électromagnétique ;
   (ii) le fait d'exposer ladite matière organique photoconductrice audit rayonnement infrarouge, l'absorption dudit rayonnement infrarouge par ledit premier exciton se traduit par la génération de porteurs de charge ; et
   (iii) le fait de détecter lesdits porteurs de charge générés ;
   et soit
   dans lequel ledit matériau dopant absorbe ladite lumière de pompage pour générer ledit premier exciton, **caractérisé en ce que** la lumière de pompage est puisée ;
   ou
   **caractérisé en ce que** la lumière de pompage est de la lumière pulsée et ledit matériau hôte absorbe ladite

lumière de pompage pour générer un exciton dans ledit matériau hôte qui se transforme en ledit premier exciton dans ledit matériau dopant.

**2.** Le procédé selon la revendication 1, dans lequel lesdits un ou plusieurs premiers excitons sont des excitons singlets.

**3.** Le procédé selon la revendication 1 ou la revendication 2, dans lequel ledit matériau hôte est choisi dans le groupe constitué des matériaux contenant du carbazole, des arylamines, des tétraarylphénylènediamines, des polymères semiconducteurs conjugués ou des mélanges de polymères, des phtalocyanines, des porphyrines, des complexes de métaux de transition, des aromatiques polycycliques $C_{60}$, et des complexes de métal, d'actinide et de lanthanide de transition, et/ou ledit matériau dopant est choisi dans le groupe constitué par les métallophtalocyanines, les métalloporphyrines, les acènes, les acènes substitués et les colorants laser.

**4.** Le procédé selon l'une quelconque des revendications précédentes, dans lequel l'absorption dudit rayonnement infrarouge par ledit premier exciton se traduit par la génération d'un deuxième exciton qui se dissocie en des porteurs de charge par relaxation vers le LUMO dudit matériau dopant.

**5.** Le procédé selon la revendication 1, dans lequel lesdits un ou plusieurs premiers excitons sont des excitons triplets.

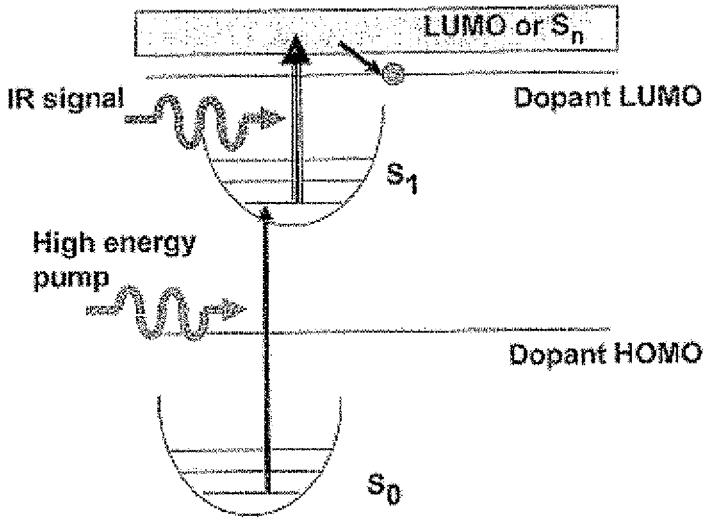


*Figure 1A*

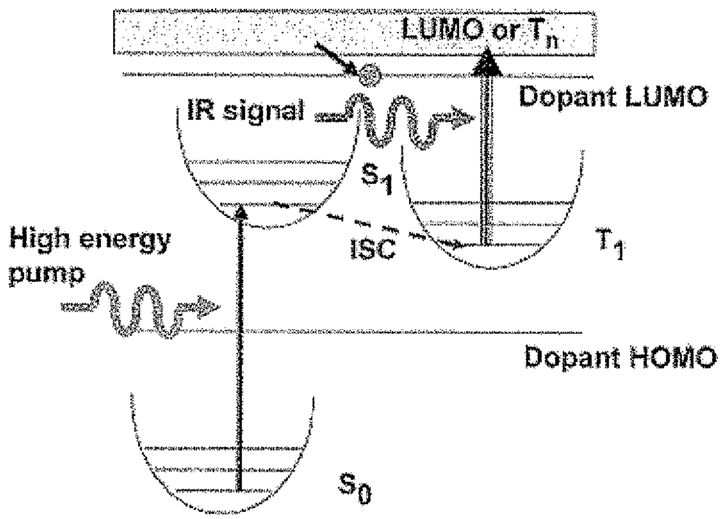


*Figure 1B*

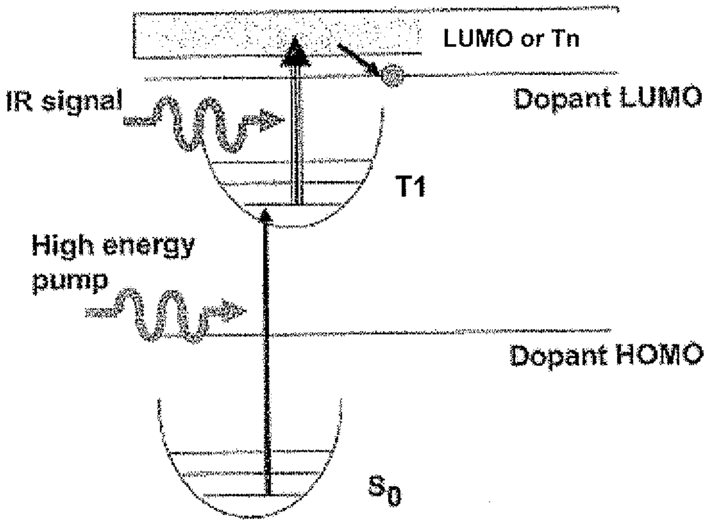


*Figure 1C*

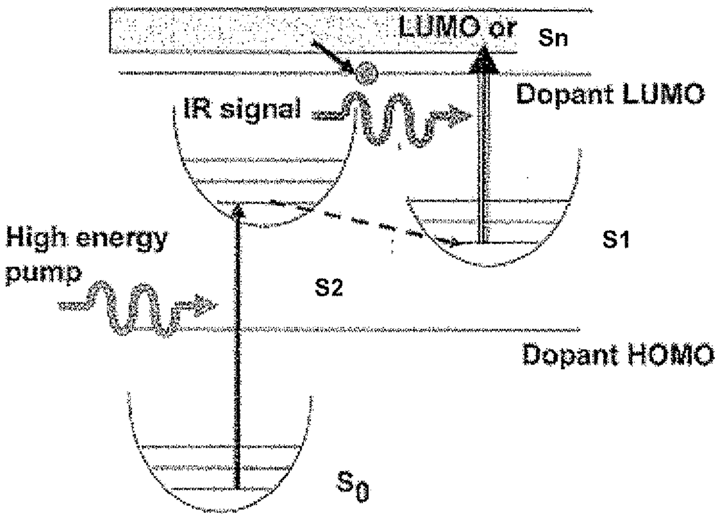


*Figure 1D*

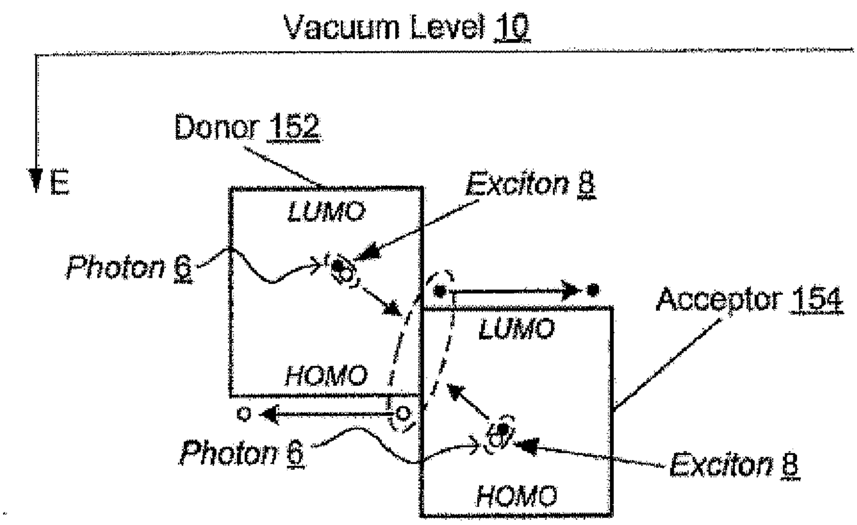


*Figure 2*

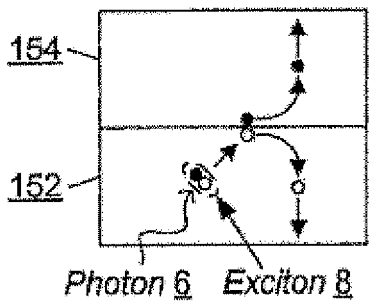


*Figure 3*

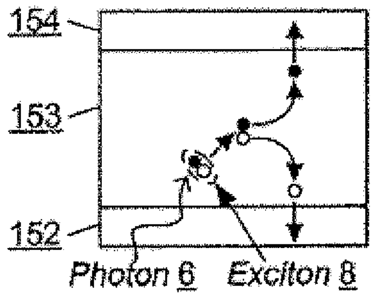


*Figure 4*

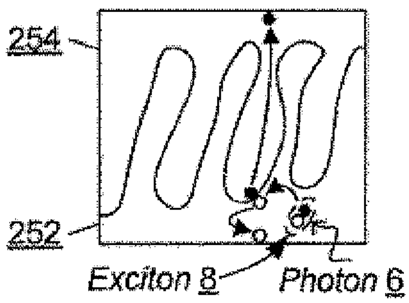


*Figure 5*

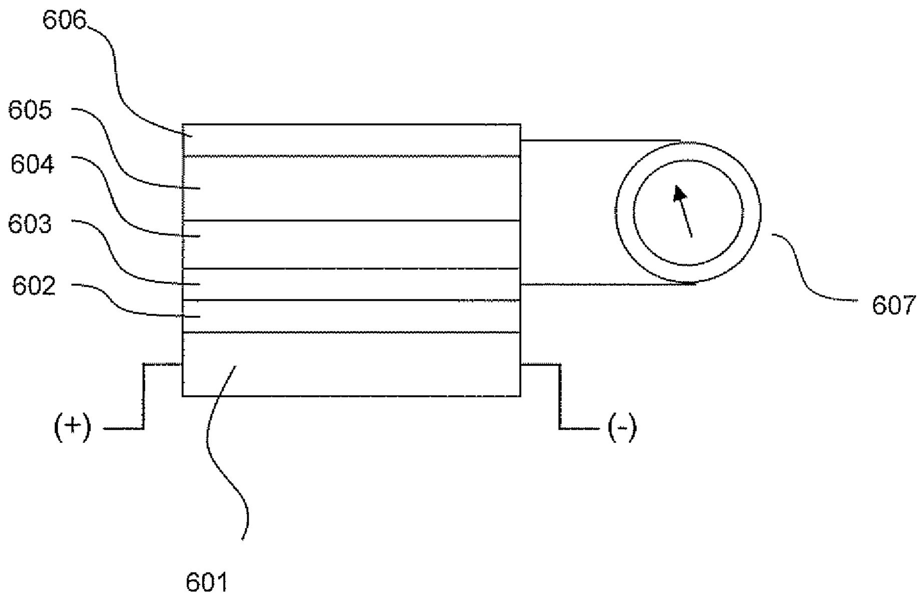


*Figure 6*

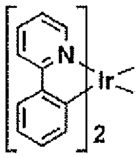
ppy

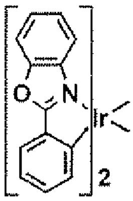
bo

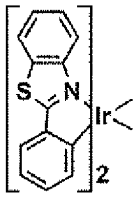
bt

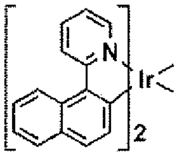
1np

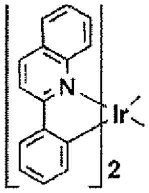
pq

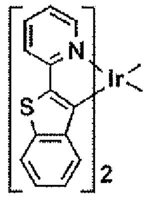
btp

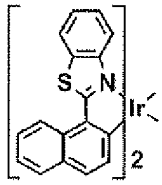
bsn

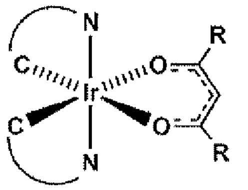

R = Me (acac)
R = *t*-Bu (dpm)

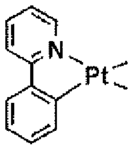
ppy

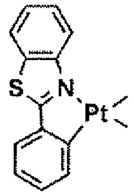
bt

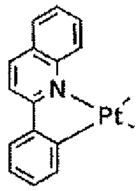
pq

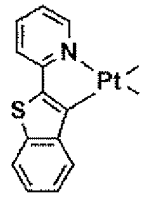
btp

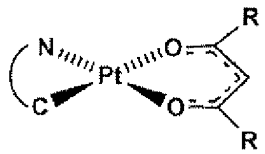
R = Me (acac)
R = *t*-Bu (dpm)

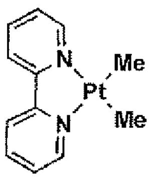
(bpy)Pt

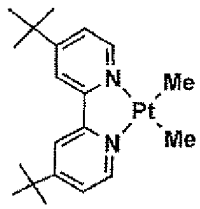
(tbbpy)Pt

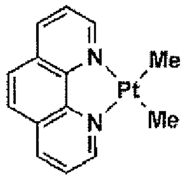
(Phen)Pt

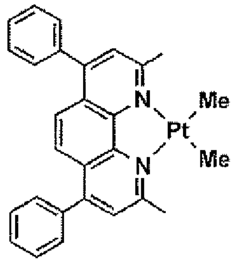
$(PhenPh_2)Pt$

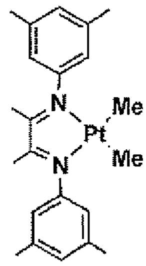
$(CyPh_2)Pt$

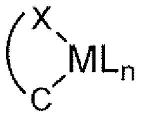
general form

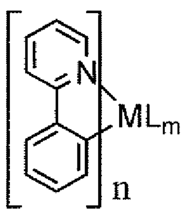
ppy

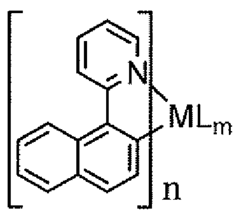
1np

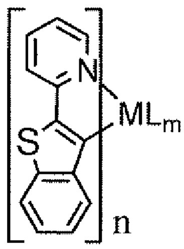
btp

M = Ir, Pt, Os, Au, etc.; L = ancilary ligand
X = N, O, P, S, etc.; n = 1-3; m = 0-4

*Figure 7*

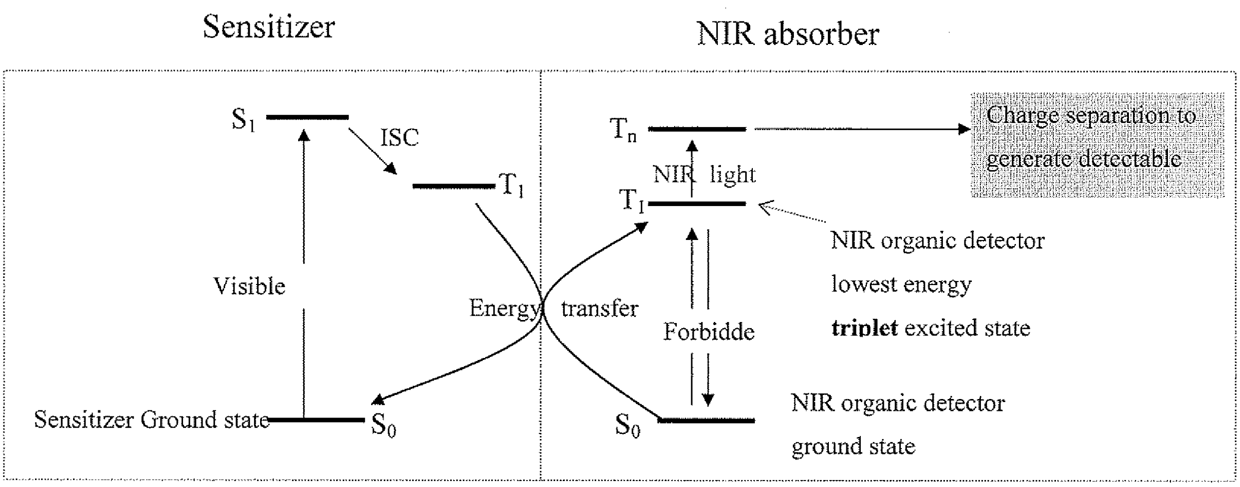
Sensitizer
NIR absorber
S1
ISC
T1
Visible
Sensitizer Ground state
S0
Energy transfer
Tn
NIR light
T1
Charge separation to generate detectable
NIR organic detector lowest energy **triplet** excited state
Forbidde
S0
NIR organic detector ground state

*Figure 8*

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description


- US 6972431 B, Forrest and Xue
- US 6657378 B, Forrest
- US 6580027 B, Forrest
- US 6352777 B, Bulovic
- WO 2007073467 A1
- WO 2007121252 A2
- US 6420031 B, Parthasarathy
- US 6013982 A
- US 6087196 A
- US 6337102 B, Forrest
- US 233470 A
- US 6294398 B
- US 6468819 B
- US 20050224113 A
- US 20050110007 A, Forrest
- US 20060032529 A1
- US 20060027802 A1
- US 054707 A, Parthasarathy
- US 5703436 A, Forrest
- US 6333458 B, Forrest
- US 6440769 B, Peumans
- US 20050266218 A, Peumans
- US 6303238 B
- US 6310360 B
- US 6830828 B
- US 6939624 B
- US 6835469 B
- WO 02074015 A
- US 20080061681 A


### Non-patent literature cited in the description


- **P. PEUMANS ; A. YAKIMOV ; S. R. FORREST.** *J. Appl. Phys.,* 2003, vol. 93, 3693
- **C. W. TANG.** *Appl. Phys. Lett.,* 1986, vol. 48, 183
- **A. SHAH ; P. TORRES ; R. TSCHARNER ; N. WYRSCH ; H. KEPPNER.** *Science,* 1999, vol. 285, 692
- **P. PEUMANS ; S. R. FORREST.** *Appl. Phys. Lett.,* 2001, vol. 79, 126
- **P. PEUMANS ; V. BULOVIC ; S. R. FORREST.** *Appl. Phys. Lett.,* 2000, vol. 76, 3855
- **S. FRAIGNE et al.** Near infrared spectral hole burning in Si-naphthalocyanine-doped solids: enhancement of the hole-burning efficiency by co-doping with C70 fullerene. *Journal of Luminescence,* July 2002, vol. 98 (1-4), 231-235
- Features of light to current transformations in organic devices. International Conference on Numerical Simulation of Optoelectronic Devices. Ajay K. Pandey, 2007, 59-60
- **A. MARTI.** Production of Photocurrent due to Intermediate-to-Conduction-Band Transitions: A Demonstration of a Key Operating Principle of the Intermediate-Band Solar Cell. *the Physical Review Letters,* 2006, vol. 97, 247701
- **SUDHAKAR MADHUSOODHANAN.** *J. Am. Chem. Soc.,* 2003, vol. 125 (26), 7796-7797
- **GARY L. MIESSLER ; DONALD A. TARR.** Inorganic Chemistry. Prentice Hall, 1998
- **BALDO et al.** Highly Efficient Phosphorescent Emission from Organic Electroluminescent Devices. *Nature,* 1998, vol. 395, 151-154
- **BALDO et al.** Very high-efficiency green organic light-emitting devices based on electrophosphorescence. *Appl. Phys. Lett.,* 1999, vol. 75 (1), 4-6
- Organic Light-Emitting Devices: Synthesis, Properties and Applications. Wiley-VCH, 2006
- **R.C. EVANS ; P. DOUGLAS ; C.J. WINSCOM.** *Coordination Chem. Rev.,* 2006, vol. 250 (15-16), 2093-2126
- **P. DJUROVICH et al.** *Dalton Trans.,* 2007, 3763-3770
- **M. SUDHAKAR et al.** *J. Am. Chem. Soc.,* 2003, vol. 125, 7796-7797